# EUROPEAN PATENT APPLICATION

(11) **EP 4 514 101 A2**
(43) Date of publication of application: **26.02.2025**
(21) Application number: 24192712.8
(22) Date of filing: 02.08.2024
(51) Int. Cl.: H10K 50/15, H10K 59/122, H10K 59/32, H10K 59/35

(54) **DISPLAY DEVICE AND WEARABLE ELECTRONIC DEVICE**

(30) Priority: 21.08.2023 KR 20230109002; 08.11.2023 KR 20230153854
(71) Applicant: Samsung Display Co., Ltd., Gyeonggi-do 17113 (KR)
(72) Inventor: YOU, Chun Gi, 17113 Yongin-si (KR); KIM, Sang Yeol, 17113 Yongin-si (KR)
(74) Representative: Marks & Clerk LLP

(57) **Abstract**

Provided is a display device including a base layer defining a trench, a first sub-pixel and a second sub-pixel at opposite sides of the trench, each of the first sub-pixel and the second sub-pixel including a first electrode on the base layer, a first emission structure on the first electrode, the first emission structure including a first hole transport layer, a first emission layer, and a first electron transport layer, a thickness of the first hole transport layer being less than a depth of the trench, a first intermediate layer on the first emission structure, a second emission structure on the first intermediate layer, the second emission structure including a second hole transport layer, a second emission layer, and a second electron transport layer, a thickness of the second hole transport layer being greater than the depth of the trench, and a second electrode on the second emission structure.

## Description

### BACKGROUND

### 1. Field

Aspects of some embodiments of the present disclosure relate to a display device and a wearable electronic device.

### 2. Description of the Related Art

An organic light emitting diode (OLED) is an active light emitting display device that has a wide viewing angle, an excellent contrast, a lightweight and slim profile, a fast response time, and is capable of low voltage driving.

One pixel may have a structure in which emission layers are stacked. The emission layers may extend commonly and continuously across sub-pixels within the pixel.

The above information disclosed in this Background section is for enhancement of understanding of the background of the present disclosure, and therefore, it may contain information that does not constitute prior art.

### SUMMARY

In a display device (e.g., an ultra-high resolution display device), the spacing between sub-pixels may be narrow. Accordingly, a leakage current (or a lateral leakage phenomenon) may occur between adjacent sub-pixels through a common emission layer, and the sub-pixels may not emit light at a desired luminance. In other words, display quality may deteriorate.

Some aspects of some embodiments of the present disclosure provide for a display device (e.g., a wearable electronic device) with improved display quality.

The objectives of the present disclosure are not limited to those described above, and other objectives that are not mentioned herein will be clearly understood from the following description by those of ordinary skill in the art.

According to some embodiments of the present disclosure, there is provided a display device including a base layer defining a trench, a first sub-pixel and a second sub-pixel at opposite sides of the trench, each of the first sub-pixel and the second sub-pixel including a first electrode on the base layer, a first emission structure on the first electrode and configured to emit light, the first emission structure including a first hole transport layer, a first emission layer, and a first electron transport layer, a thickness of the first hole transport layer being less than a depth of the trench, a first intermediate layer on the first emission structure, a second emission structure on the first intermediate layer and configured to emit light, the second emission structure including a second hole transport layer, a second emission layer, and a second electron transport layer, a thickness of the second hole transport layer being greater than the depth of the trench, and a second electrode on the second emission structure.

The trench may include a first trench surrounding the first sub-pixel in a plan view, and a second trench surrounding the second sub-pixel in a plan view, and the first trench and the second trench may be spaced apart from each other.

The depth of the trench may be about 2,500 Å to about 8,500 Å, a width of the trench may be about 800 Å to about 1,700 Å, the thickness of the first hole transport layer may be about 1,200 Å to about 1,650 Å, and the thickness of the second hole transport layer may be about 3,600 Å to about 4,400 Å.

The first hole transport layer may include a material different from that of the second hole transport layer.

A glass transition temperature of the second hole transport layer may be higher than a glass transition temperature of the first hole transport layer by about 10% to about 30%.

The glass transition temperature of the second hole transport layer may be higher than the glass transition temperature of the first hole transport layer by about 15°C to about 35°C.

A thickness of the second electrode may be about 100 Å to about 190 Å.

A step of the second electrode on the trench may be about 500 Å or less.

A thickness of the first emission structure may be less than the depth of the trench, and a thickness of the second emission structure may be greater than the depth of the trench.

The thickness of the first emission structure may be less than or equal to about 70% of the depth of the trench, and the thickness of the second emission structure may be greater than or equal to about 160% of the depth of the trench.

The depth of the trench may be about 2,500 Å to about 8,500 Å, a width of the trench may be about 800 Å to about 1,700 Å, the thickness of the first emission structure may be about 1,650 Å to about 2,050 Å, and the thickness of the second emission structure may be about 4,500 Å to about 5,400 Å.

The first emission structure and the first intermediate layer of the first sub-pixel may be spaced apart from the first emission structure and the first intermediate layer of the second sub-pixel at the trench, and at least a portion of the second emission structure of the first sub-pixel and at least a portion of the second emission structure of the second sub-pixel may be connected on the trench.

The first sub-pixel and the second sub-pixel may each include a third emission structure located between the first electrode and the first emission structure and configured to emit light, and a second intermediate layer located between the third emission structure and the first emission structure, the third emission structure and the second intermediate layer of the first sub-pixel may be spaced apart from the third emission structure and the second intermediate layer of the second sub-pixel at the trench.

The first emission structure may be configured to emit light of a first color, and the second emission structure may be configured to emit light of a second color different from the first color.

The first emission structure and the second emission structure may be configured to emit light of a same color.

According to other embodiments of the present disclosure, there is provided a display device including a first electrode on a base layer, a first emission structure on the first electrode and configured to emit light, the first emission structure including a first hole transport layer, a first emission layer, and a first electron transport layer, an intermediate layer on the first emission structure, a second emission structure on the intermediate layer and configured to emit light, the second emission structure includes a second hole transport layer, a second emission layer, and a second electron transport layer, a glass transition temperature of the second hole transport layer being higher than a glass transition temperature of the first hole transport layer by about 10% to about 30%, and a second electrode on the second emission structure.

A glass transition temperature of the second hole transport layer may be higher than a glass transition temperature of the first hole transport layer by about 15 °C to about 35 °C.

According to other embodiments of the present disclosure, there is provided a wearable electronic device including a display panel configured to emit light, and at least one lens on the display panel, the display panel including a base layer defining a trench, and a first sub-pixel and a second sub-pixel at opposite sides of the trench, each of the first sub-pixel and the second sub-pixel including a first electrode on the base layer, a first emission structure on the first electrode and configured to emit light, the first emission structure including a first hole transport layer, a first emission layer, and a first electron transport layer, a thickness of the first hole transport layer being less than a depth of the trench, an intermediate layer on the first emission structure, a second emission structure on the intermediate layer and configured to emit light, the second emission structure including a second hole transport layer, a second emission layer, and a second electron transport layer, a thickness of the second hole transport layer being greater than the depth of the trench, and a second electrode on the second emission structure.

A glass transition temperature of the second hole transport layer may be higher than a glass transition temperature of the first hole transport layer by about 10% to about 30%.

A glass transition temperature of the second hole transport layer may be higher than a glass transition temperature of the first hole transport layer by about 15 °C to about 35 °C.

At least some of the above and other features of the invention are set out in the claims.

Aspects of some other embodiments are included in the detailed description and drawings.

### BRIEF DESCRIPTION OF THE DRAWINGS

The above and other aspects and features of the present disclosure will be more clearly understood from the following detailed description of the illustrative, non-limiting embodiments with reference to the accompanying drawings.
FIG. 1 is a block diagram illustrating a display device, according to some embodiments of the present disclosure.
FIG. 2 is a block diagram illustrating a sub-pixel included in the display device of FIG. 1, according to some embodiments of the present disclosure.
FIG. 3 is a circuit diagram illustrating the sub-pixel of FIG. 2, according to some embodiments of the present disclosure.
FIG. 4 is a plan view illustrating the display device of FIG. 1, according to some embodiments of the present disclosure.
FIG. 5 is an exploded perspective view illustrating the display device of FIG. 4, according to some embodiments of the present disclosure.
FIGS. 6A, 6B, and 6C are plan views illustrating some embodiments of pixels included in the display device of FIG. 5, according to some embodiments of the present disclosure.
FIG. 7 is a cross-sectional view taken along the line I-I' illustrating the display device of FIG. 6A, according to some embodiments of the present disclosure.
FIG. 8 is an enlarged cross-sectional view of a portion of the display device of FIG. 7, according to some embodiments of the present disclosure.
FIG. 9 is a cross-sectional view illustrating an emission layer included in the display device of FIG. 7, according to some embodiments of the present disclosure.
FIG. 10 is an image illustrating the display device of FIG. 8, according to some embodiments of the present disclosure.
FIG. 11 is a cross-sectional view illustrating another embodiment of the display device taken along the line I-I' of FIG. 6A, according to some embodiments of the present disclosure.
FIG. 12 is an enlarged cross-sectional view of a portion of the display device of FIG. 11, according to some embodiments of the present disclosure.
FIG. 13 is a cross-sectional view illustrating an emission layer included in the display device of FIG. 11, according to some embodiments of the present disclosure.
FIG. 14 is a plan view illustrating a pixel included in the display device of FIG. 5, according to some embodiments of the present disclosure.
FIG. 15 is a cross-sectional view taken along line II-II' illustrating the display device of FIG. 14, according to some embodiments of the present disclosure.
FIG. 16 is a cross-sectional view taken along line II-II' illustrating the display device of FIG. 14, according to some embodiments of the present disclosure.
FIG. 17 is an enlarged cross-sectional view of a portion of the display device of FIG. 16, according to some embodiments of the present disclosure.
FIG. 18 is a block diagram illustrating a display system, according to some embodiments of the present disclosure.
FIG. 19 is a perspective view illustrating an application example of the display system of FIG. 18, according to some embodiments of the present disclosure.
FIG. 20 is a diagram illustrating the application example of FIG. 19 worn by a user, according to some embodiments of the present disclosure.

### DETAILED DESCRIPTION

Hereinafter, some embodiments will be described in more detail with reference to the accompanying drawings. It should be noted that only the parts necessary to understand operations in accordance with the present disclosure will be described below, and the description of the other parts will not be provided in order to not obscure the gist of the present disclosure. In some embodiments, the present disclosure is not limited to the embodiments described herein and may be embodied in other forms. Hereinafter, the embodiment will be described in more detail so that those of ordinary skill in the art can easily carry out the technical idea of the present disclosure.

It will be understood that when a portion is referred to as being "connected to" another portion, it may be "directly connected to" the other portion or "indirectly connected to" the other portion with intervening portions therebetween. The terminology used herein is intended to describe specific embodiments and is not intended to limit the present disclosure. It will be understood that the terms "comprise," "include," or "have" as used herein specify the presence of stated elements, but do not preclude the presence or addition of one or more other elements. The expression "at least one of X, Y, and Z," "at least one of X, Y, or Z" and "at least one selected from the group consisting of X, Y, and Z" may be interpreted as one X, one Y, one Z, or any combination of two or more of X, Y, and Z (e.g., XYZ, XYY, YZ, ZZ, etc.). The terms "or" and "and/or" as used herein include any combination of one or more of the elements.

It will be understood that although the terms such as "first," "second," etc. may be used to describe various elements, these elements should not be limited by these terms. These terms are only used to distinguish one element from another. Accordingly, a first element may be referred to as a second element without departing from the scope of the present disclosure.

Spatially relative terms such as "below," "above," etc. may be used for descriptive purposes, thereby describing the relationship between one element or feature and another element(s) or feature(s) as illustrated in the drawings. Spatially relative terms are intended to include different directions in use, operation, and/or manufacture, in addition to the directions depicted in the drawings. For example, when the device illustrated in the figures is turned over, elements depicted as being located "below" other elements or features are located "above" the other elements or features. Accordingly, in some embodiments, the term "below" may include both up and down directions. In some embodiments, the device may be oriented in other directions (e.g., rotated by 90 degrees or in other orientations), and thus, the spatially relative terms as used herein should be interpreted accordingly.

Some embodiments are described with reference to the accompanying drawings in relation to functional blocks, units, and/or modules. Those of ordinary skill in the art will understand that these blocks, units, and/or modules are physically implemented by logic circuits, discrete components, microprocessors, hard-wired circuits, memory elements, wiring connections, and other electronic circuitry. This may be formed by using semiconductor-based manufacturing technologies or other manufacturing technologies. The blocks, units, and/or modules implemented by a microprocessor or other similar hardware may be programmed and controlled by using software to perform various functions discussed herein, and may optionally be driven by firmware and/or software. In some embodiments, the respective blocks, units, and/or modules may be implemented by dedicated hardware, or may be implemented as a combination of dedicated hardware that performs some functions and a processor (e.g., one or more programmed microprocessors and associated circuits) that performs other functions. In some embodiments, the blocks, units, and/or modules may be physically separated into two or more individual blocks, units, and/or modules that interact within the scope of the present disclosure. In some embodiments, the blocks, units, and/or modules may be physically combined into more complex blocks, units, and/or modules without departing from the scope of the present disclosure.

Various embodiments are described with reference to drawings that schematically illustrate non-limiting embodiments. Accordingly, it will be expected that the shapes may vary depending on, for example, tolerances and/or manufacturing techniques. Therefore, the embodiments disclosed herein should not be construed as limited to the illustrated specific shapes, but should be construed to include changes in shapes that occur, for example, as a result of manufacturing. As such, the shapes illustrated in the drawings may not depict the actual shapes of the areas of the device, and the present embodiments are not limited thereto.

When a certain embodiment may be implemented differently, a specific process order may be different from the described order. For example, two consecutively described processes may be performed at the same or substantially at the same time or may be performed in an order opposite to the described order.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

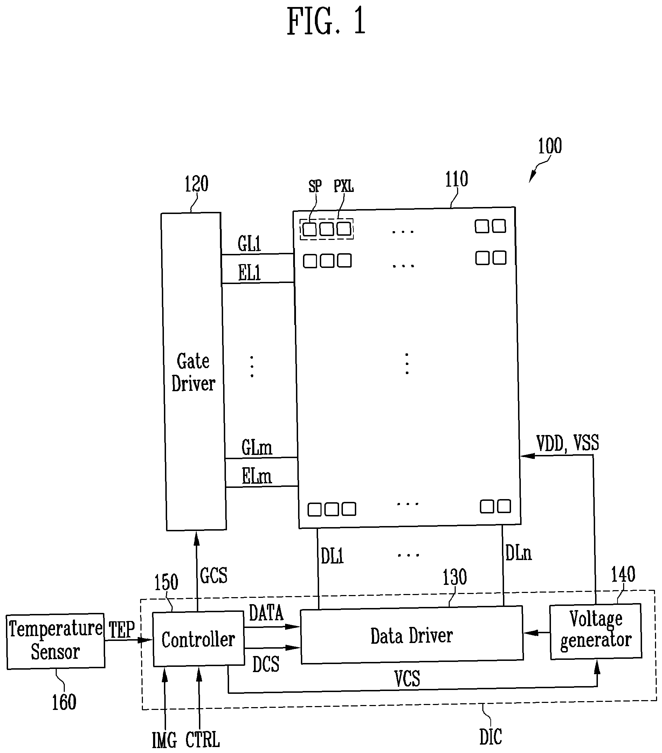

FIG. 1 is a block diagram illustrating a display device, according to some embodiments of the present disclosure.

Referring to FIG. 1, a display device 100 may include a display panel 110, a gate driver 120, a data driver 130, a voltage generator 140, and a controller 150.

The display panel 110 may include sub-pixels SP. The sub-pixels SP may be connected to the gate driver 120 through first to m-th gate lines GL1 to GLm. The sub-pixels SP may be connected to the data driver 130 through first to n-th data lines DL1 to DLn.

The sub-pixels SP may each include at least one light emitting element configured to generate light. For example, the light emitting element may be an organic light emitting diode having a tandem structure. Accordingly, the sub-pixels SP may each generate light of a specific color, such as red, green, blue, cyan, magenta, yellow, and/or the like. Two or more sub-pixels among the sub-pixels SP may constitute one pixel PXL capable of expressing full color. For example, as illustrated in FIG. 1, three sub-pixels may constitute one pixel PXL.

The gate driver 120 may be connected to the sub-pixels SP arranged in the row direction through the first to m-th gate lines GL1 to GLm. The gate driver 120 may output gate signals to the first to m-th gate lines GL1 to GLm in response to a gate control signal GCS. In some embodiments, the gate control signal GCS may include a start signal indicating the start of each frame, a horizontal synchronization signal for outputting the gate signals in synchronization with a timing at which data signals are applied, and/or the like.

In some embodiments, the display panel 110 may further include first to m-th emission control lines EL1 to ELm connected to the sub-pixels SP arranged in the row direction. In this case, the gate driver 120 may output emission control signals to the first to m-th emission control lines EL1 to ELm, similar to the gate signals. For example, the gate driver 120 may include an emission control driver that outputs the emission control signals.

The gate driver 120 may be disposed on one side of the display panel 110. However, the present disclosure is not limited thereto. For example, the gate driver 120 may be divided into two or more physically and/or logically separated drivers. Such drivers may be located (or provided) on one side of the display panel 110 and on another side of the display panel 110 opposite to the one side. As such, the gate driver 120 may be arranged around the display panel 110 in various shapes in accordance with some embodiments.

The data driver 130 may be connected to the sub-pixels SP arranged in the column direction through the first to n-th data lines DL1 to DLn. The data driver 130 receives image data DATA and a data control signal DCS from the controller 150. The data driver 130 operates in response to the data control signal DCS. In some embodiments, the data control signal DCS may include a source start pulse, a source shift clock, a source output enable signal, and/or the like.

The data driver 130 may apply, to the first to n-th data lines DL1 to DLn, data signals having grayscale voltages corresponding to the image data DATA by using the voltages from the voltage generator 140. When the gate signal is applied to each of the first to m-th gate lines GL1 to GLm, the data signals corresponding to the image data DATA may be applied to the data lines DL1 to DLm. Accordingly, the corresponding sub-pixels SP may generate light corresponding to the data signals. Accordingly, an image may be displayed on the display panel 110.

In some embodiments, the gate driver 120 and the data driver 130 may include complementary metal-oxide semiconductor (CMOS) circuit elements.

The voltage generator 140 may operate in response to a voltage control signal VCS from controller 150. The voltage generator 140 is configured to generate a plurality of voltages and provide the generated voltages to components of the display device 100. For example, the voltage generator 140 may be configured to generate a plurality of voltages by receiving an input voltage from the outside of the display device 100, adjusting the received voltage, and regulating the adjusted voltage.

The voltage generator 140 may generate a first power supply voltage VDD and a second power supply voltage VSS, and the generated first and second power supply voltages VDD and VSS may be provided to the sub-pixels SP. The second power supply voltage VSS may have a lower voltage level than the first power supply voltage VDD. In some other embodiments, the first power supply voltage VDD or the second power supply voltage VSS may be provided by devices outside the display device 100.

In some embodiments, the voltage generator 140 may generate various voltages. For example, the voltage generator 140 may generate an initialization voltage to be applied to the sub-pixels SP. For example, during a sensing operation of sensing electrical characteristics of the transistors and/or light emitting elements of the sub-pixels SP, a certain reference voltage may be applied to the first to n-th data lines DL1 to DLn, and the voltage generator 140 may generate the reference voltage.

The controller 150 may control overall operations of the display device 100. The controller 150 may receive, from the outside, input image data IMG and a control signal CTRL for controlling the displaying of the input image data IMG. The controller 150 may provide the gate control signal GCS, the data control signal DCS, and the voltage control signal VCS in response to the control signal CTRL.

The controller 150 may convert the input image data IMG into image data DATA suitable for the display device 100 or the display panel 110 and output the image data DATA. In some embodiments, the controller 150 may output the image data DATA by aligning the input image data IMG so as to be suitable for the sub-pixels SP in units of rows.

Two or more components of the data driver 130, the voltage generator 140, and the controller 150 may be mounted on one integrated circuit. As illustrated in FIG. 1, the data driver 130, the voltage generator 140, and the controller 150 may be included in a driver integrated circuit DIC. In this case, the data driver 130, the voltage generator 140, and the controller 150 may be functionally separate components within one driver integrated circuit DIC. In some other embodiments, at least one of the data driver 130, the voltage generator 140, and the controller 150 may be provided as a component separate from the driver integrated circuit DIC.

The display device 100 may include at least one temperature sensor 160. The temperature sensor 160 is configured to sense ambient temperature and generate temperature data TEP representing the sensed temperature. In some embodiments, the temperature sensor 160 may be disposed adjacent to the display panel 110 and/or the driver integrated circuit DIC.

The controller 150 may control various operations of the display device 100 in response to temperature data TEP. In some embodiments, the controller 150 may adjust the luminance of the image output from the display panel 110 in response to the temperature data TEP. For example, the controller 150 may control the data signals and the first and second power supply voltages VDD and VSS by controlling components such as the data driver 130 and/or the voltage generator 140.

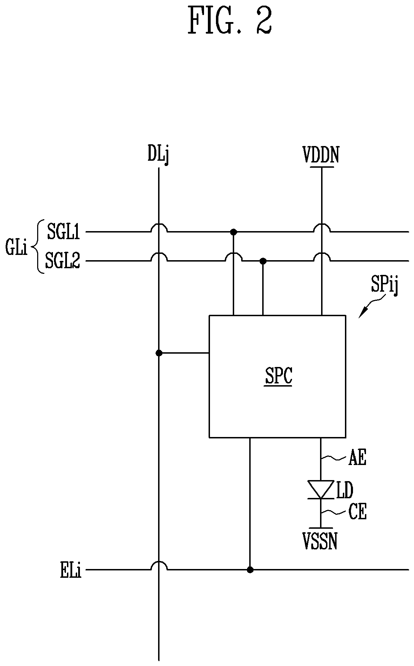

FIG. 2 is a block diagram illustrating the sub-pixel included in the display device of FIG. 1, according to some embodiments of the present disclosure.

FIG. 2 illustrates sub-pixels SPij arranged in an i-th row (where i is an integer greater than or equal to 1 and less than or equal to m) and a j-th column (where j is an integer greater than or equal to 1 and less than or equal to n).

Referring to FIG. 2, the sub-pixel SPij may include a sub-pixel circuit SPC (or a pixel circuit) and a light emitting element LD.

The light emitting element LD may be connected between a first power supply voltage node VDDN (or a first power line) and a second power supply voltage node VSSN (or a second power line). At this time, the first power supply voltage node VDDN is a node configured to transmit the first power supply voltage VDD of FIG. 1, and the second power supply voltage node VSSN is a node configured to transmit the second power supply voltage VSS of FIG. 1.

An anode electrode AE of the light emitting element LD may be connected to the first power supply voltage node VDDN through the sub-pixel circuit SPC, and a cathode electrode CE of the light emitting element LD may be connected to the second power supply voltage node VSSN. For example, the anode electrode AE of the light emitting element LD may be connected to the first power supply voltage node VDDN through one or more transistors included in the sub-pixel circuit SPC.

The sub-pixel circuit SPC may be connected to an i-th gate line GLi among the gate lines GL1 to GLm of FIG. 1, an i-th emission control line ELi among the emission control lines EL1 to ELm of FIG. 1, and a j-th data line DLj among the data lines DL1 to DLn of FIG. 1, and may control the light emitting element LD to generate light according to signals received through the signal lines.

The i-th gate line GLi may include one or more sub-gate lines (or scan lines). In some embodiments, as illustrated in FIG. 2, the i-th gate line GLi may include first and second sub-gate lines SGL1 and SGL2. The sub-pixel circuit SPC may operate in response to the gate signals (or the scan signals) received through the first and second sub-gate lines SGL1 and SGL2 (or the first and second scan lines).

The sub-pixel circuit SPC may receive the data signal through the j-th data line DLj. The sub-pixel circuit SPC may store a voltage corresponding to the data signal in response to at least one of the gate signals received through the first and second sub-gate lines SGL1 and SGL2. Accordingly, the light emitting element LD may generate light with a luminance corresponding to the data signal.

In some embodiments, the sub-pixel SPij may be further connected to the i-th emission control line ELi. The sub-pixel circuit SPC may operate in response to the emission control signal received through the i-th emission control line ELi. For example, the sub-pixel circuit SPC may adjust a current flowing from the first power supply voltage node VDDN through the light emitting element LD to the second power supply voltage node VSSN according to the stored voltage in response to the emission control signal received through the i-th emission control line ELi.

In some embodiments, the i-th emission control line ELi may include one or more sub-emission control lines. When the i-th emission control line ELi includes two or more sub-emission control lines, the sub pixel circuit SPC may operate in response to the emission control signals received through the corresponding sub-emission control lines.

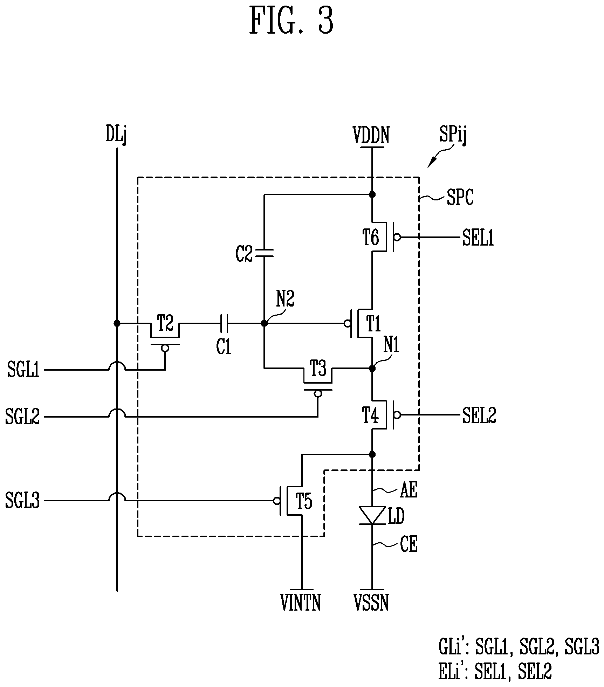

FIG. 3 is a circuit diagram illustrating the sub-pixel of FIG. 2, according to some embodiments of the present disclosure.

Referring to FIG. 3, the sub-pixel SPij may include a sub-pixel circuit SPC and a light emitting element LD.

The sub-pixel circuit SPC may be connected to the i-th gate line GLi', the i-th emission control line ELi', and the j-th data line DLj. Compared to the i-th gate line GLi of FIG. 2, the i-th gate line GLi' may further include a third sub-gate line SGL3 (or a third scan line). Compared to the i-th emission control line ELi of FIG. 2, the i-th emission control line ELi' may include a first sub-emission control line SEL1 and a second sub-emission control line SEL2.

The sub-pixel circuit SPC may include first to sixth transistors T1 to T6 and first and second capacitors C1 and C2.

The first transistor T1 may be connected between the first power supply voltage node VDDN and the first node N1. The gate (or the gate electrode) of the first transistor T1 may be connected to the second node N2, and thus, the first transistor T1 may be turned on in response to the voltage level of the second node N2. The first transistor T1 may be referred to as a driving transistor.

The second transistor T2 may be connected between the j-th data line DLj and the second node N2. The gate of the second transistor T2 may be connected to the first sub-gate line SGL1, and thus, the second transistor T2 may be turned on in response to the gate signal of the first sub-gate line SGL1. The second transistor T2 may be referred to as a switching transistor.

The third transistor T3 may be connected between the first node N1 and the second node N2. The gate of the third transistor T3 may be connected to the second sub-gate line SGL2, and thus, the third transistor T3 may be turned on in response to the gate signal of the second sub-gate line SGL2.

The fourth transistor T4 may be connected between the first node N1 and the anode electrode AE of the light emitting element LD. The gate of the fourth transistor T4 may be connected to the second sub-emission control line SEL2, and thus, the fourth transistor T4 may be turned on in response to the emission control signal of the second sub-emission control line SEL2.

The fifth transistor T5 may be connected between the anode electrode AE of the light emitting element LD and the initialization voltage node VINTN (or the initialization voltage line). The initialization voltage node VINTN may be configured to transmit an initialization voltage. In some embodiments, the initialization voltage may be provided by the voltage generator 140 of FIG. 1. In another embodiment, the initialization voltage may be provided by a device outside the display device 100. The gate of the fifth transistor T5 may be connected to the third sub-gate line SGL3, and thus, the fifth transistor T5 may be turned on in response to the gate signal of the third sub-gate line SGL3.

The sixth transistor T6 may be connected between the first power supply voltage node VDDN and the first transistor T1. The gate of the sixth transistor T6 may be connected to the first sub-emission control line SEL1, and thus, the sixth transistor T6 may be turned on in response to the emission control signal of the first sub-emission control line SEL1.

The first capacitor C1 may be connected between the second transistor T2 and the second node N2. The second capacitor C2 may be connected between the first power supply voltage node VDDN and the second node N2.

As such, the sub-pixel circuit SPC may include first to sixth transistors T1 to T6 and first and second capacitors C1 and C2. However, the present disclosure is not limited thereto. The sub-pixel circuit SPC may be implemented as one of various types (e.g., suitable kinds) of circuits including a plurality of transistors and one or more capacitors. For example, the sub-pixel circuit SPC may include two transistors and one capacitor. According to some embodiments of the sub-pixel circuit SPC, the number of sub-gate lines included in the i-th gate line GLi' and the number of sub-emission control lines included in the i-th emission control line ELi' may be changed.

The first to sixth transistors T1 to T6 may each be a P-type transistor. The first to sixth transistors T1 to T6 may each be a metal oxide silicon field effect transistor (MOSFET). However, the present disclosure is not limited thereto. For example, at least one of the first to sixth transistors T1 to T6 may be replaced with an N-type transistor.

In some embodiments, the first to sixth transistors T1 to T6 may include an amorphous silicon semiconductor, a polycrystalline silicon semiconductor, a single crystal silicon semiconductor, an oxide semiconductor, and/or the like.

The light emitting element LD may include the anode electrode AE, the cathode electrode CE, and the emission layer. The emission layer may be arranged between the anode electrode AE and the cathode electrode CE. The first transistor T1 may be turned on in response to the voltage of the second node N2, and the fourth and sixth transistors T4 and T6 may be turned on in response to the emission control signals (e.g., turn-on voltage level, low level, and/or the like) applied to the first and second sub-emission control lines SEL1 and SEL2. Accordingly, a current may flow from the first power supply voltage node VDDN to the second power supply voltage node VSSN. The light emitting element LD may emit light according to the amount of current flowing therethrough.

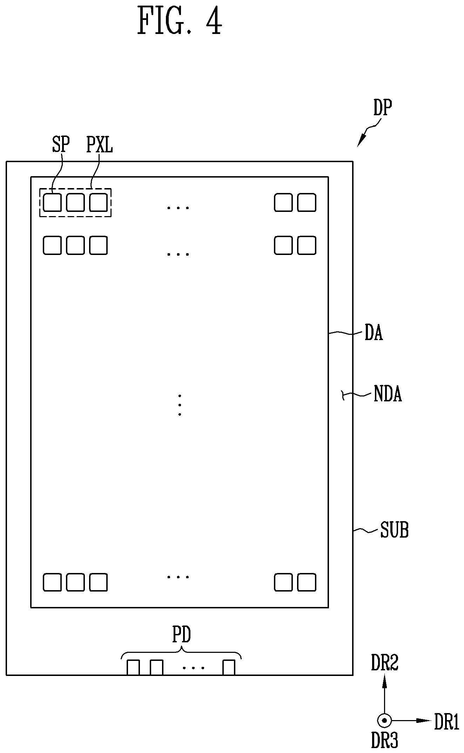

FIG. 4 is a plan view illustrating the display device of FIG. 1, according to some embodiments of the present disclosure.

FIG. 4 illustrates a display panel DP constituting the display device.

Referring to FIG. 4, the display panel DP may include a display area DA and a non-display area NDA. The display panel DP may display an image through the display area DA. The non-display area NDA may be disposed around the display area DA.

The display panel DP may include a substrate SUB, sub-pixels SP, and pads PD.

When the display panel DP is used as a display screen for head mounted display (HMD), virtual reality (VR) devices, mixed reality (MR) devices, augmented reality (AR) devices, and/or the like, the display panel DP may be located very close to a user's eyes. In this case, the sub-pixels SP with relatively high integration may be required. In order to increase the integration of the sub-pixels SP, the substrate SUB may be provided as a silicon substrate. The sub-pixels SP and/or the display panel DP may be formed on the substrate SUB, which is a silicon substrate. The display device (see 100 of FIG. 1) including the display panel DP formed on the substrate SUB, which is a silicon substrate, may be referred to as an OLED on Silicon (OLEDoS) display device.

The sub-pixels SP may be disposed in the display area DA on the substrate SUB. The sub-pixels SP may be disposed in a matrix form in the first direction DR1 and the second direction DR2 crossing the first direction DR1. However, the present disclosure is not limited thereto. For example, the sub-pixels SP may be disposed in a zigzag shape in the first direction DR1 and the second direction DR2. For example, the sub-pixels SP may be disposed in a PENTILE^{™} shape. The first direction DR1 may be a row direction and the second direction DR2 may be a column direction.

As described with reference to FIG. 1, two or more sub-pixels among the plurality of sub-pixels SP may constitute one pixel PXL.

Components for controlling the sub-pixels SP may be disposed in the non-display area NDA on the substrate SUB. For example, the lines connected to the sub-pixels SP, such as the first to m-th gate lines GL1 to GLm and the first to n-th data lines DL1 to DLn in FIG. 1, may be disposed in the non-display area NDA.

In some embodiments, the gate driver 120 of FIG. 1 may be mounted on the display panel DP and disposed in the non-display area NDA. In another embodiment, the gate driver 120 may be implemented as an integrated circuit separate from the display panel DP.

The pads PD may be disposed in the non-display area NDA on the substrate SUB. The pads PD may be electrically connected to the sub-pixels SP through the lines. For example, the pads PD may be connected to the sub-pixels SP through the first to n-th data lines DL1 to DLn.

The pads PD may interface the display panel DP to other components of the display device (see 100 of FIG. 1). In some embodiments, the voltages and the signals necessary for the operations of the components included in the display panel DP may be provided from the driver integrated circuit DIC of FIG. 1 through the pads PD. For example, the first to n-th data lines DL1 to DLn may be connected to the driver integrated circuit DIC through the pads PD. For example, the first and second power supply voltages VDD and VSS may be received from the driver integrated circuit DIC through the pads PD. When the gate driver 120 is mounted on the display panel DP, the gate control signal GCS may be transmitted from the driver integrated circuit DIC to the gate driver 120 through the pads PD.

In some embodiments, a circuit board may be electrically connected to the pads PD by using a conductive adhesive member such as an anisotropic conductive film. At this time, the circuit board may be a flexible circuit board (FPCB) or a flexible film made of a flexible material. The driver integrated circuit DIC may be mounted on the circuit board and electrically connected to the pads PD.

In some embodiments, the display area DA may have various shapes. The display area DA may have a closed loop shape including straight and/or curved sides. For example, the display area DA may have shapes such as a polygonal shape, a circular shape, a semicircular shape, or an elliptical shape.

In some embodiments, the display panel DP may have a flat display surface. In some other embodiments, the display panel DP may have a display surface that is at least partially round. In some embodiments, the display panel DP may be bendable, foldable, or rollable. In these cases, the display panel DP and/or the substrate SUB may include materials with flexible properties.

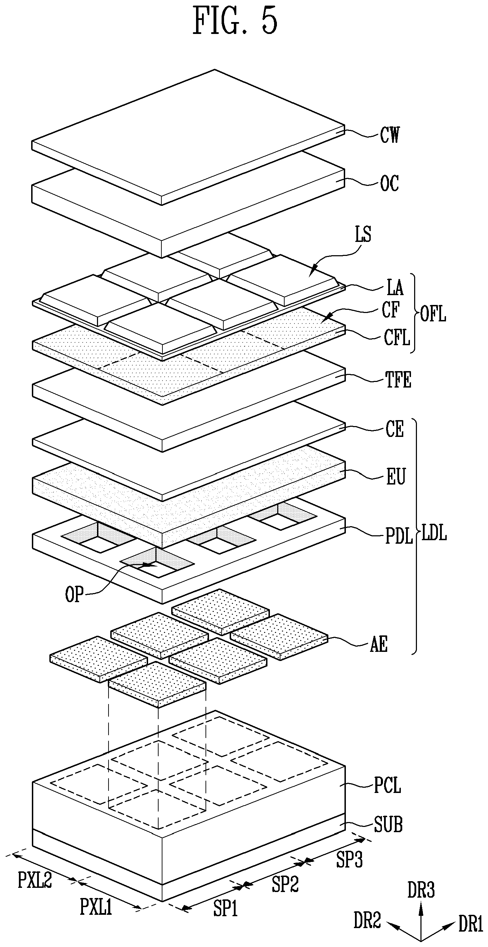

FIG. 5 is an exploded perspective view illustrating the display device of FIG. 4, according to some embodiments of the present disclosure.

FIG. 5 schematically illustrates a portion of the display panel DP corresponding to two pixels PXL1 and PXL2 among the pixels PXL of FIG. 4 for clarity and concise explanation. Portions of the display panel DP corresponding to the remaining pixels may be configured in a similar manner.

Referring to FIGS. 4 and 5, the first and second pixels PXL1 and PXL2 may each include first, second, and third sub-pixels SP1, SP2, and SP3. However, the present disclosure is not limited thereto. For example, the first and second pixels PXL1 and PXL2 may each include four sub-pixels or two sub-pixels.

FIG. 5 illustrates that the first to third sub-pixels SP1 to SP3 each have a rectangular shape, when viewed from a third direction DR3 (e.g., a thickness direction) crossing the first and second directions DR1 and DR2, and have the same sizes. However, the present disclosure is not limited thereto. The first to third sub-pixels SP1 to SP3 may each be modified to have various shapes.

The display panel DP may include a substrate SUB, a pixel circuit layer PCL, a light emitting element layer LDL, an encapsulation layer TFE, an optical functional layer OFL, an overcoat layer OC, and a cover window CW.

In some embodiments, the substrate SUB may include a silicon wafer substrate formed by using a semiconductor process. The substrate SUB may include a semiconductor material suitable for forming circuit elements. For example, the semiconductor material may include silicon, germanium, and/or silicon-germanium. The substrate SUB may be provided from a bulk wafer, an epitaxial layer, a silicon-on-insulator (SOI) layer, or a semiconductor-on-insulator (SeOI) layer. In some other embodiments, the substrate SUB may include a glass substrate. In some other embodiments, the substrate SUB may include a polyimide (PI) substrate.

The pixel circuit layer PCL may be disposed on the substrate SUB. The substrate SUB and/or the pixel circuit layer PCL may each include insulating layers and conductive patterns disposed between the insulating layers. For example, the conductive patterns of the pixel circuit layer PCL may function as at least some of the circuit elements, lines, and/or the like. The conductive patterns may include copper, but the present disclosure is not limited thereto.

The pixel circuit layer PCL may include a sub-pixel circuit SPC of each of the first to third sub-pixels (see SP1 to SP3 of FIG. 2). For example, the pixel circuit layer PCL may include transistors and capacitors as circuit elements. The transistors may each include a semiconductor pattern including source and drain regions and a channel region, a gate electrode overlapping the semiconductor pattern, and source and drain electrodes connected to the source and drain regions. In some embodiments, when the substrate SUB is provided as a silicon substrate, the semiconductor pattern may be provided in the substrate SUB, and the gate electrodes and the source and drain electrodes may be provided in the pixel circuit layer PCL. In some embodiments, when the substrate SUB is provided as a glass substrate or a PI substrate, the semiconductor pattern, the gate electrode, and the source and drain electrodes may be provided in the pixel circuit layer PCL. The capacitors may each include electrodes spaced apart from each other. For example, the capacitors may each include electrodes spaced apart from each other on a plane defined by the first and second directions DR1 and DR2. For example, the capacitors may each include electrodes spaced apart from each other in the third direction DR3 with an insulating layer therebetween.

The pixel circuit layer PCL may include signal lines connected to each of the first to third sub-pixels SP1 to SP3. For example, the pixel circuit layer PCL may include lines such as the gate line, the emission control line, and the data line. The lines may further include a line connected to the first power supply voltage node VDDN of FIG. 2. In some embodiments, the lines may further include a line connected to the second power supply voltage node VSSN of FIG. 2.

The light emitting element layer LDL may include anode electrodes AE, an emission structure EU, a cathode electrode CE, and a pixel defining layer PDL.

The anode electrodes AE (or the first electrodes) may be disposed on the pixel circuit layer PCL. The anode electrodes AE may be in contact with the circuit elements of the pixel circuit layer PCL (e.g., the fourth transistor T4 in FIG. 3). The anode electrodes AE may include an opaque conductive material capable of reflecting light, but the present disclosure is not limited thereto.

The pixel defining layer PDL may be disposed on the anode electrodes AE. The pixel defining layer PDL may include openings OP respectively exposing portions of the anode electrodes AE. The openings OP of the pixel defining layer PDL may be understood as emission areas corresponding to the first to third sub-pixels SP1 to SP3, respectively.

In some embodiments, the pixel defining layer PDL may include an inorganic material. In this case, the pixel defining layer PDL may include multiple stacked inorganic layers. For example, the pixel defining layer PDL may include silicon oxide (SiOₓ) and silicon nitride (SiNₓ). In some other embodiments, the pixel defining layer PDL may include an organic material. However, the material of the pixel defining layer PDL is not limited thereto.

The emission structure EU may be disposed on the anode electrodes AE exposed by the openings OP of the pixel defining layer PDL. The emission structure EU may include an electron transport layer configured to transport electrons, a hole transport layer configured to transport holes, and an emission layer in which holes and electrons recombine to form excitons and light is generated.

In some embodiments, the emission structure EU may fill the openings OP of the pixel defining layer PDL and may be completely disposed on the upper portion of the pixel defining layer PDL. In other words, the emission structure EU may extend across the first to third sub-pixels SP1 to SP3. In this case, some layers in the emission structure EU may be disconnected or bent at the boundaries between the first to third sub-pixels SP1 to SP3. However, the present disclosure is not limited thereto. For example, portions of the emission structure EU corresponding to the first to third sub-pixels SP1 to SP3 may be separated from each other, and may be disposed within the openings OP of the pixel defining layer PDL.

The cathode electrode CE may be disposed on the emission structure EU. The cathode electrode CE may extend across the first to third sub-pixels SP1 to SP3. As such, the cathode electrode CE may serve as a common electrode for the first to third sub-pixels SP1 to SP3.

The cathode electrode CE may be a thin metal layer having a thickness sufficient to transmit light emitted from the emission structure EU. The cathode electrode CE may be formed of a metal material or a transparent conductive material to have a relatively thin thickness. In some embodiments, the cathode electrode CE may include at least one of various transparent conductive materials, including indium tin oxide, indium zinc oxide, indium tin zinc oxide, aluminium zinc oxide, gallium zinc oxide, zinc tin oxide, or gallium tin oxide. However, the material of the cathode electrode CE is not limited thereto.

One of the anode electrodes AE, a portion of the emission structure EU overlapping one of the anode electrodes AE, and a portion of the cathode electrode CE overlapping one of the anode electrodes AE may be understood as constituting one light emitting element (see LD of FIG. 2). In other words, the light emitting elements of the first to third sub-pixels SP1 to SP3 may each include one anode electrode, a portion of the emission structure EU overlapping the anode electrode, and a portion of the cathode electrode CE overlapping the anode electrode. In each of the first to third sub-pixels SP1 to SP3, holes injected from the anode electrode AE and electrons injected from the cathode electrode CE are transported into the emission structure EU to form excitons. When the excitons transition from an excited state to a ground state, light may be generated. The luminance of light may be determined according to the amount of a current flowing through the emission structure EU. The wavelength range of the generated light may be determined according to the configuration of the emission structure EU.

The encapsulation layer TFE may be disposed on the cathode electrode CE. The encapsulation layer TFE may cover the light emitting element layer LDL and/or the pixel circuit layer PCL. The encapsulation layer TFE may be configured to prevent, or reduce the occurrence of, oxygen and/or moisture from penetrating into the light emitting element layer LDL. In some embodiments, the encapsulation layer TFE may include a structure in which one or more inorganic layers and one or more organic layers are alternately stacked. For example, the inorganic layer may include silicon nitride, silicon oxide, or silicon oxynitride (SiOₓN_{y}). For example, the organic layer may include an organic insulating material such as polyacrylates resin, epoxy resin, phenolic resin, polyamides resin, polyimides rein, unsaturated polyesters resin, polyphenylene ethers resin, polyphenylene sulfides resin, or benzocyclobutene (BCB). However, the materials of the organic layer and the inorganic layer of the encapsulation layer TFE are not limited thereto.

In order to improve encapsulation efficiency of the encapsulation layer TFE, the encapsulation layer TFE may further include a thin film including aluminium oxide (AlOₓ). The thin film including aluminium oxide may be formed through atomic layer deposition (ALD). However, the present disclosure is not limited thereto. The encapsulation layer TFE may further include a thin film formed of at least one of various materials suitable for improving encapsulation efficiency.

The optical functional layer OFL is disposed on the encapsulation layer TFE. The optical functional layer OFL may include a color filter layer CFL and a lens array LA.

The color filter layer CFL may be disposed between the encapsulation layer TFE and the lens array LA. The color filter layer CFL may be configured to filter light emitted from the emission structure EU and selectively output light in a wavelength range or color light corresponding to each sub-pixel. The color filter layer CFL may include color filters CF respectively corresponding to the first to third sub-pixels SP1 to SP3, and the color filters CF may each pass light in a wavelength range corresponding to the sub-pixel. For example, the color filter corresponding to the first sub-pixel SP1 may pass red color light, the color filter corresponding to the second sub-pixel SP2 may pass green color light, and the color filter corresponding to the third sub-pixel SP3 may pass blue color light. At least some of the color filters CF may not be provided according to the light emitted from the emission structure EU in each sub-pixel.

The lens array LA may be disposed on the color filter layer CFL (or the encapsulation layer TFE). The lens array LA may include lenses LS respectively corresponding to the first to third sub-pixels SP1 to SP3. Each of the lenses LS may improve light output efficiency by outputting the light emitted from the emission structure EU through an intended path. The lens array LA may have a relatively high refractive index. For example, the lens array LA may have a refractive index of 1.5 to 1.7. However, the refractive index of the lens array LA is not limited to this, and the refractive index of the lens array LA may vary depending on the design of the system to which the display device is applied. In some embodiments, the lenses LS may include an organic material.

In some embodiments, compared to the opening OP of the pixel defining layer PDL, at least some of the color filters CF of the color filter layer CFL and at least some of the lenses LS of the lens array LA may be shifted in a direction parallel to a plane defined by the first and second directions DR1 and DR2. For example, in the central area of the display area DA, the opening OP of the pixel defining layer PDL may completely overlap the corresponding color filter CF of the color filter layer CFL and the corresponding lens LS of the lens array LA. In a region of the display area DA adjacent to the non-display area NDA, the opening OP of the pixel defining layer PDL may partially overlap the corresponding color filter CF of the color filter layer CFL and the corresponding lens LS of the lens array LA. Accordingly, in the center of the display area DA, the light emitted from the emission structure EU may be efficiently output in the normal direction of the display surface, and in the outside of the display area DA, the light emitted from the emission structure EU may be efficiently output in a direction inclined by a certain angle with respect to the normal direction of the display surface.

The overcoat layer OC may be disposed on the lens array LA. The overcoat layer OC may cover the optical functional layer OFL, the encapsulation layer TFE, the emission structure EU, and/or the pixel circuit layer PCL. The overcoat layer OC may include various materials suitable for protecting underlying layers thereof from foreign substances such as dust, moisture, and/or the like. For example, the overcoat layer OC may include an organic insulating layer. For example, the overcoat layer OC may include epoxy, but the present disclosure is not limited thereto. The overcoat layer OC may have a lower refractive index than the lens array LA.

The cover window CW may be disposed on the overcoat layer OC. The cover window CW may be configured to protect the underlying layers thereof. The cover window CW may have a higher refractive index than the overcoat layer OC. The cover window CW may include glass, but the present disclosure is not limited thereto. For example, the cover window CW may be an encapsulation glass configured to protect components disposed therebelow. In some other embodiments, the cover window CW may not be provided.

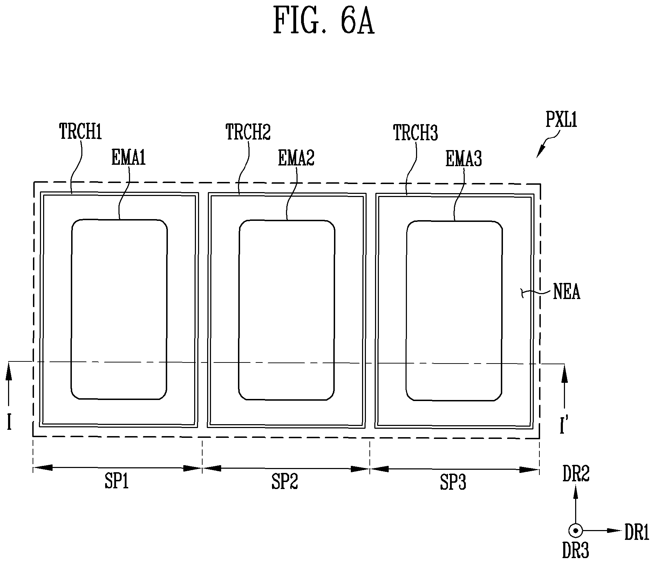

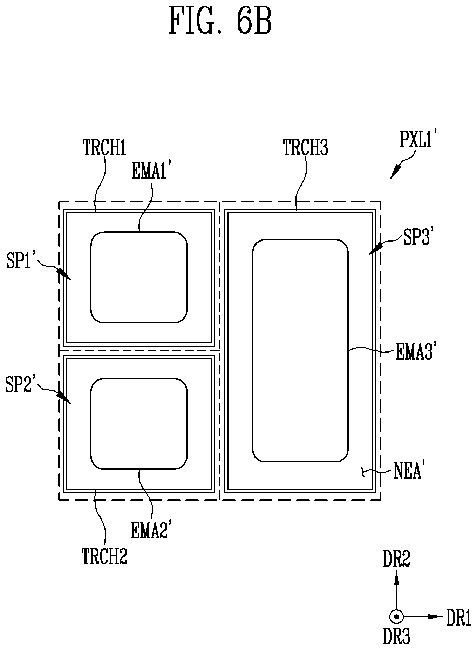

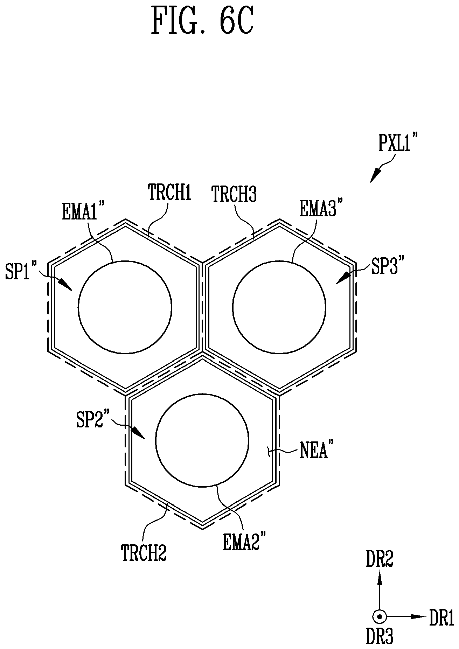

FIGS. 6A, 6B, and 6C are plan views illustrating some embodiments of pixels included in the display device of FIG. 5, according to some embodiments of the present disclosure.

FIG. 6A schematically illustrates the first pixel PXL1 of FIG. 5 for clarity and concise explanation. The remaining pixels may be configured similarly to the first pixel PXL1.

First, referring to FIGS. 4, 5, and 6A, the first pixel PXL1 may include first to third sub-pixels SP1 to SP3 arranged in the first direction DR1.

The first sub-pixel SP1 may include a first emission area EMA1 and a non-emission area NEA around the first emission area EMA1. The second sub-pixel SP2 may include a second emission area EMA2 and a non-emission area NEA around the second emission area EMA2. The third sub-pixel SP3 may include a third emission area EMA3 and a non-emission area NEA around the third emission area EMA3.

The first emission area EMA1 may be an area in which light is emitted from a portion of the emission structure (see EU of FIG. 5) corresponding to the first sub-pixel SP1. The second emission area EMA2 may be an area in which light is emitted from a portion of the emission structure EU corresponding to the second sub-pixel SP2. The third emission area EMA3 may be an area in which light is emitted from a portion of the emission structure EU corresponding to the third sub-pixel SP3. As described with reference to FIG. 5, each of the emission areas may be understood as the opening OP of the pixel defining layer PDL corresponding to each of the first to third sub-pixels SP1 to SP3.

In some embodiments, trenches TRCH1 to TRCH3 may be disposed between adjacent sub-pixels among the first to third sub-pixels SP1 to SP3. For example, one sub-pixel and a neighboring sub-pixel may be provided with a trench therebetween (e.g., at least a portion of a trench may positioned between one sub-pixel and a neighboring sub-pixel). The trenches TRCH1 to TRCH3 may be formed by recessing or penetrating a base layer (e.g., the upper surface of the pixel defining layer PDL) for the arrangement of the emission structure EU of FIG. 5. For example, in a plan view, the first trench TRCH1 may be disposed to surround the first sub-pixel SP1 along the edge of the first sub-pixel SP1, and may have a closed loop shape corresponding to the planar shape of the first sub-pixel SP1. Similar to the first trench TRCH1, in a plan view, the second trench TRCH2 may be disposed to surround the second sub-pixel SP2 along the edge of the second sub-pixel SP2, and the third trench TRCH3 may be disposed to surround the third sub-pixel SP3 along the edge of the third sub-pixel SP3. In this case, the first trench TRCH1 and the second trench TRCH2 may be disposed in the boundary area (or the non-emission area NEA) between the first sub-pixel SP1 and the second sub-pixel SP2, and the second trench TRCH2 and the third trench TRCH3 may be disposed in the boundary area between the second sub-pixel SP2 and the third sub-pixel SP3.

The trenches TRCH1 to TRCH3 may be separated from each other (e.g., may be spaced apart from each other in the first direction DR1 and/or the second directions DR2) and independent of each other. In this case, the trenches TRCH1 to TRCH3 may each have a uniform width in the extending direction. As will be described below, the cathode electrode remains connected at the top of the trenches TRCH1 to TRCH3 without being disconnected, and the first to third sub-pixels SP1 to SP3 may normally operate or emit light. For example, the cathode electrode may extend (e.g., may extend continuously) over the trenches TRCH1 to TRCH3.

On the other hand, although FIG. 6A illustrates that the first to third sub-pixels SP1 to SP3 are disposed in the first direction DR1 and have a rectangular planar shape, the present disclosure is not limited thereto.

Referring to FIG. 6B, the first pixel PXL1' may include first, second, and third sub-pixels SP1', SP2', and SP3', the first sub-pixel SP1' and the second sub-pixel SP2' may be disposed in the second direction DR2, and the third sub-pixel SP3' may be disposed in the first direction DR1 with respect to each of the first and second sub-pixels SP1' and SP2'.

The second sub-pixel SP2' may have a larger area than the first sub-pixel SP1', and the third sub-pixel SP3' may have a larger area than the second sub-pixel SP2'. Accordingly, the second emission area EMA2' may have a larger area than the first emission area EMA1', and the third emission area EMA3' may have a larger area than the second emission area EMA2'. However, the present disclosure is not limited thereto. For example, the first and second sub-pixels SP1' and SP2' may have substantially the same area, and the third sub-pixel SP3' may have a larger area than each of the first and second sub-pixels SP1' and SP2'. As such, the areas of the first to third sub-pixels SP1' to SP3' may vary in some embodiments.

Referring to FIG. 6C, the first pixel PXL1" may include first, second, and third sub-pixels SP1", SP2", and SP3". The first to third sub-pixels SP1" to SP3" may each have a polygonal shape when viewed from the third direction DR3. For example, as illustrated in FIG. 6C, the first to third sub-pixels SP1" to SP3" may each have a hexagonal shape.

The first to third emission areas EMA1" to EMA3" of the first to third sub-pixels SP1" to SP3" may each have a circular shape when viewed from the third direction DR3. However, the present disclosure is not limited thereto. For example, the first to third emission areas EMA1" to EMA3" may each have a polygonal shape.

The first and third sub-pixels SP1" and SP3" may each be disposed in the first direction DR1. The second sub-pixel SP2" may be disposed in a direction inclined by an acute angle (or a diagonal direction) with respect to the second direction DR2 for the first sub-pixel SP1".

The arrangement of the sub-pixels illustrated in FIGS. 6A, 6B, and 6C is an example, and the present disclosure is not limited thereto. The pixels may each include two or more sub-pixels. The sub-pixels may be disposed in various ways. The sub-pixels may each have various shapes, and the emission areas may also have various shapes.

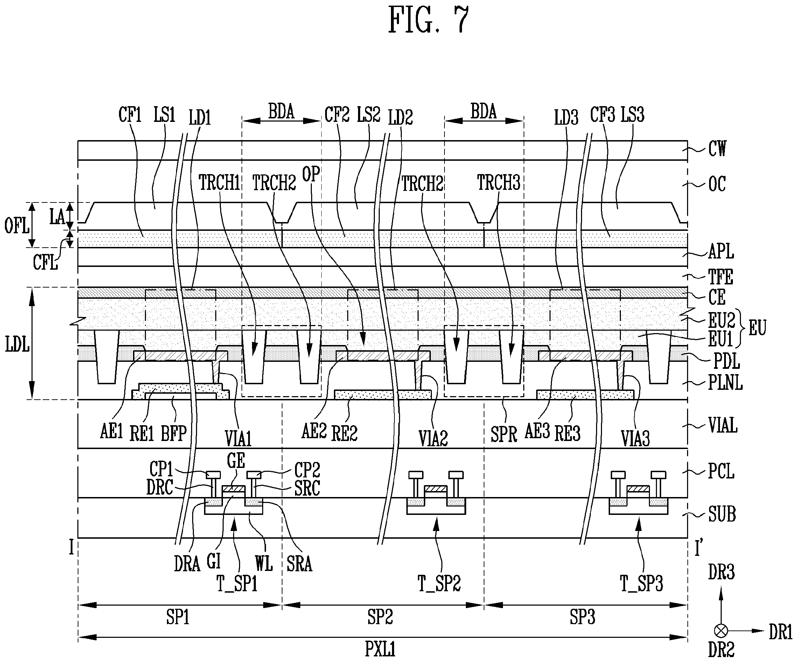

FIG. 7 is a cross-sectional view taken along the line I-I' illustrating the display device of FIG. 6A, according to some embodiments of the present disclosure.

Referring to FIG. 7, a substrate SUB and a pixel circuit layer PCL disposed on the substrate SUB may be provided.

The substrate SUB may include a silicon wafer substrate formed by using a semiconductor process. For example, the substrate SUB may include silicon, germanium, and/or silicon-germanium.

The pixel circuit layer PCL may be disposed on the substrate SUB. The substrate SUB and the pixel circuit layer PCL may include circuit elements of each of first to third sub-pixels SP1 to SP3. For example, the substrate SUB and the pixel circuit layer PCL may include a transistor T_SP1 of the first sub-pixel SP1, a transistor T_SP2 of the second sub-pixel SP2, and a transistor T_SP3 of the third sub-pixel SP3. The transistor T_SP1 of the first sub-pixel SP1 may be one of the transistors included in the sub-pixel circuit (see SPC of FIG. 2) of the first sub-pixel SP1, the transistor T_SP2 of the second sub-pixel SP2 may be one of the transistors included in the sub-pixel circuit SPC of the second sub-pixel SP2, and the transistor T_SP3 of the third sub-pixel SP3 may be one of the transistors included in the sub-pixel circuit SPC of the third sub-pixel SP3. FIG. 7 illustrates one of the transistors of each sub-pixel for clarity and concise explanation, and the remaining circuit elements are omitted.

The transistor T_SP1 of the first sub-pixel SP1 may include a source region SRA, a drain region DRA, and a gate electrode GE.

The source region SRA and the drain region DRA may be disposed in the substrate SUB. A well WL formed through an ion implantation process may be disposed in the substrate SUB, and the source region SRA and the drain region DRA may be spaced apart from each other within the well WL. An area between the source region SRA and the drain region DRA within the well WL may be defined as a channel region.

The gate electrode GE may overlap the channel region between the source region SRA and the drain region DRA and may be disposed on the pixel circuit layer PCL. The gate electrode GE may be spaced apart from the well WL or the channel region by an insulating material such as a gate insulating layer GI. The gate electrode GE may include a conductive material.

A plurality of layers included in the pixel circuit layer PCL may include insulating layers and conductive patterns disposed between the insulating layers, and the conductive patterns may include first and second conductive patterns CP1 and CP2. The first conductive pattern CP1 may be electrically connected to the drain region DRA through a drain connection portion DRC that penetrates one or more insulating layers. The second conductive pattern CP2 may be electrically connected to the source region SRA through a source connection part SRC that penetrates one or more insulating layers.

As the gate electrode GE and the first and second conductive patterns CP1 and CP2 are connected to other circuit elements and/or lines, the transistor T_SP1 of the first sub-pixel SP1 may be provided as one of the transistors of the first sub-pixel SP1.

The transistor T_SP2 of the second sub-pixel SP2 and the transistor T_SP3 of the third sub-pixel SP3 may each be configured similarly to the transistor T_SP1 of the first sub-pixel SP1.

As such, the substrate SUB and the pixel circuit layer PCL may include circuit elements of each of the first to third sub-pixels SP1 to SP3.

A via layer VIAL may be disposed on the pixel circuit layer PCL. The via layer VIAL may cover the pixel circuit layer PCL and may have a flat surface as a whole. The via layer VIAL may be configured to planarize steps on the pixel circuit layer PCL. The via layer VIAL may include at least one of silicon oxide (SiOₓ), silicon nitride (SiNₓ), or silicon carbon nitride (SiCN), but the present disclosure is not limited thereto.

A light emitting element layer LDL may be disposed on the via layer VIAL. The light emitting element layer LDL may include first to third reflective electrodes RE1 to RE3, a planarization layer PLNL, first to third anode electrodes AE1 to AE3, a pixel defining layer PDL, an emission structure EU, and a cathode electrode CE.

The first to third reflective electrodes RE1 to RE3 may be respectively disposed in first to third sub-pixels SP1 to SP3 on the via layer VIAL. The first to third reflective electrodes RE1 to RE3 may come into contact with circuit elements of the pixel circuit layer PCL through vias that penetrate the via layer VIAL.

The first to third reflective electrodes RE1 to RE3 may function as full mirrors that reflect light emitted from the emission structure EU toward the display screen (or the cover window CW). The first to third reflective electrodes RE1 to RE3 may each include a metal material suitable for light reflection. The first to third reflective electrodes RE1 to RE3 may include at least one of aluminium (Al), silver (Ag), magnesium (Mg), platinum (Pt), palladium (Pd), gold (Au), nickel (Ni), neodymium (Nd), iridium (Ir), chromium (Cr), titanium (Ti), or an alloy of two or more materials selected therefrom, but the present disclosure is not limited thereto.

In some embodiments, a buffer electrode may be disposed below each of the first to third reflective electrodes RE1 to RE3. The buffer electrode may improve electrical connection characteristics between the corresponding reflective electrode and the circuit element of the pixel circuit layer PCL. The buffer electrode may have a multilayer structure. The multilayer structure may include titanium (Ti), titanium nitride (TiN), tantalum nitride (TaN), and/or the like, but the present disclosure is not limited thereto. In some embodiments, the corresponding reflective electrode may be located between multiple layers of the buffer electrode.

A buffer pattern BFP may be disposed on at least one of the first to third reflective electrodes RE1 to RE3. The buffer pattern BFP may include an inorganic material such as silicon carbon nitride, but the present disclosure is not limited thereto. By disposing the buffer pattern BFP, the height of the corresponding reflective electrode in the third direction DR3 may be adjusted. For example, the buffer pattern BFP may be disposed between the first reflective electrode RE1 and the via layer VIAL to adjust the height of the first reflective electrode RE1.

The first to third reflective electrodes RE1 to RE3 may function as full mirrors, and the cathode electrode CE may function as a half mirror. The light emitted from the emission structure EU may be amplified, at least in part, by reciprocating between the corresponding reflective electrode and the cathode electrode CE, and the amplified light may be output through the cathode electrode CE. As such, a distance between the respective reflective electrodes and the cathode electrode CE may be understood as a resonance distance for the light emitted from the emission structure EU.

The first sub-pixel SP1 may have a shorter resonance distance than other sub-pixels due to the buffer pattern BFP. The resonance distance adjusted in this manner may allow light in a specific wavelength range (e.g., red color) to be effectively and efficiently amplified. Accordingly, the first sub-pixel SP1 may effectively and efficiently output light in the corresponding wavelength range.

Although FIG. 7 illustrates that the buffer pattern BFP is provided to the first sub-pixel SP1 and is not provided to the second and third sub-pixels SP2 and SP3, the present disclosure is not limited thereto. The buffer pattern may also be provided in at least one of the second or third sub-pixels SP2 or SP3 to adjust the resonance distance of at least one of the second or third sub-pixels SP2 or SP3. For example, the first to third sub-pixels SP1 to SP3 may correspond to red, green, and blue, respectively. The distance between the first reflective electrode RE1 and the cathode electrode CE may be shorter than the distance between the second reflective electrode RE2 and the cathode electrode CE. The distance between the second reflective electrode RE2 and the cathode electrode CE may be shorter than the distance between the third reflective electrode RE3 and the cathode electrode CE.

The planarization layer PLNL (or the base layer) may be disposed on the via layer VIAL and the first to third reflective electrodes RE1 to RE3. The planarization layer PLNL may planarize the steps between the first to third reflective electrodes RE1 to RE3 and may provide a base surface for the emission structure EU. The planarization layer PLNL may generally cover the first to third reflective electrodes RE1 to RE3 and the via layer VIAL and may have a flat surface. The planarization layer PLNL may include an organic material. In some embodiments, the planarization layer PLNL may not be provided.

The first to third anode electrodes AE1 to AE3 (or the first electrodes) respectively overlapping the first to third reflective electrodes RE1 to RE3 may be disposed on the planarization layer PLNL. When viewed from the third direction DR3, the first to third anode electrodes AE1 to AE3 may have similar shapes to the emission areas EMA1 to EMA3 of the first to third sub-pixels SP1 to SP3 in FIGS. 6A to 6C. The first to third anode electrodes AE1 to AE3 may be in direct contact with the emission structure EU (or the semiconductor layer thereof) and may form an energy barrier at the interface. The first to third anode electrodes AE1 to AE3 may be respectively connected to the first to third reflective electrodes RE1 to RE3. The first anode electrode AE1 may be connected to the first reflective electrode RE1 through the first via VIA1 that penetrates the planarization layer PLNL. The second anode electrode AE2 may be connected to the second reflective electrode RE2 through the second via VIA2 that penetrates the planarization layer PLNL. The third anode electrode AE3 may be connected to the third reflective electrode RE3 through the third via VIA3 that penetrates the planarization layer PLNL.

In some embodiments, the first to third anode electrodes AE1 to AE3 may each include a transparent conductive material such as indium tin oxide (ITO), indium zinc oxide (IZO), zinc oxide (ZnOx), indium gallium zinc oxide (IGZO), or indium tin zinc oxide (ITZO). However, the materials of the first to third anode electrodes AE1 to AE3 are not limited thereto. For example, the first to third anode electrodes AE1 to AE3 may each include titanium nitride.

In some embodiments, insulating layers may be further provided to adjust the height of one or more of the first to third anode electrodes AE1 to AE3. Insulating layers may be disposed between one or more of the first to third anode electrodes AE1 to AE3 and the corresponding reflective electrodes. In this case, the planarization layer PLNL and/or the buffer pattern BFP may not be provided. For example, the first to third sub-pixels SP1 to SP3 may correspond to red, green, and blue, respectively. The distance between the first anode electrode AE1 and the cathode electrode CE may be shorter than the distance between the second anode electrode AE2 and the cathode electrode CE. The distance between the second anode electrode AE2 and the cathode electrode CE may be shorter than the distance between the third anode electrode AE3 and the cathode electrode CE.

A pixel defining layer PDL may be disposed on portions of the first to third anode electrodes AE1 to AE3 and the planarization layer PLNL. The pixel defining layer PDL may include openings OP exposing portions of the first to third anode electrodes AE1 to AE3. The openings OP of the pixel defining layer PDL may define the emission areas of the first to third sub-pixels SP1 to SP3. As such, the pixel defining layer PDL may be disposed in the non-emission area NEA of FIG. 6A and may define the first to third emission areas EMA1 to EMA3 of FIG. 6A.

A separator SPR may be provided in a boundary area BDA between neighboring sub-pixels.

The separator SPR may cause a discontinuity to be formed in the emission structure EU overlapping the boundary area BDA. For example, due to the separator SPR, the first emission structure EU1 of the emission structure EU may be disconnected at the boundary area BDA. The separator SPR may be provided in the pixel defining layer PDL and the planarization layer PLNL, or may be provided on the pixel defining layer PDL.

In some embodiments, the pixel defining layer PDL may include one or more trenches TRCH1 to TRCH3 as the separator SPR in the boundary area BDA. For example, the one or more tranches TRCH1 to TRCH3 may separate (e.g., may be located (or provided) between one or more structures of neighboring sub-pixels. For example, as illustrated in FIG. 7, the first and second trenches TRCH1 and TRCH2 may be provided as the separator in the boundary area BDA between the first sub-pixel SP1 and the second sub-pixel SP2, and the second and third trenches TRCH2 and TRCH3 may be provided as the separator in the boundary area BDA between the second sub-pixel SP2 and the third sub-pixel SP3.

In some embodiments, the trenches TRCH1 to TRCH3 may penetrate the pixel defining layer PDL and partially penetrate the planarization layer PLNL. In some embodiments, the trenches TRCH1 to TRCH3 may penetrate the pixel defining layer PDL and the planarization layer PLNL, and may partially penetrate the via layer VIAL. In some embodiments, the pixel defining layer PDL may not be disposed in the trenches TRCH1 to TRCH3, and most of the trenches TRCH1 to TRCH3 may be empty space (or void). However, the present disclosure is not limited thereto. For example, a portion of the pixel defining layer PDL may be disposed in the trenches TRCH1 to TRCH3.

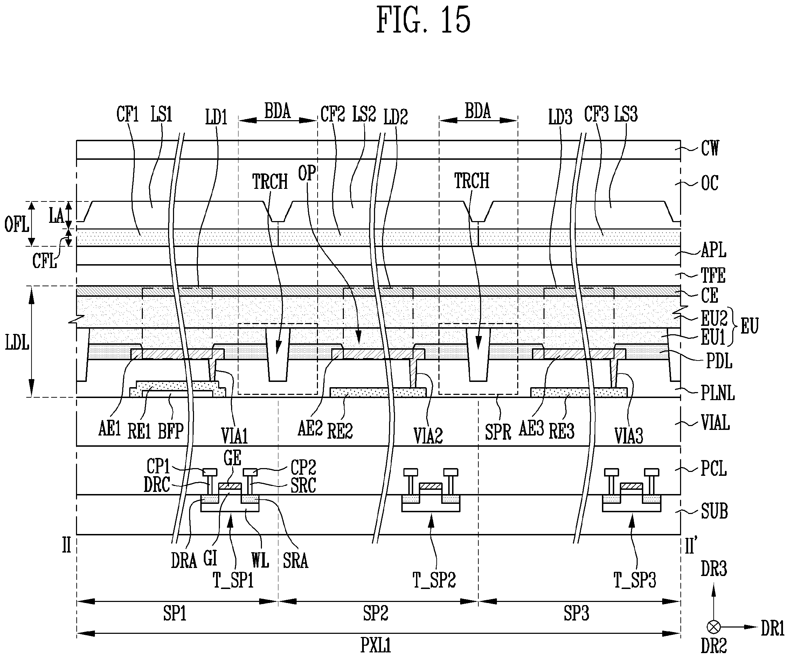

Although FIG. 7 illustrates that two trenches are provided in the boundary area BDA, the present disclosure is not limited thereto. For example, the pixel defining layer PDL may include one trench in the boundary area BDA (see FIG. 15). Alternatively, the pixel defining layer PDL may include three or more trenches in the boundary area BDA.

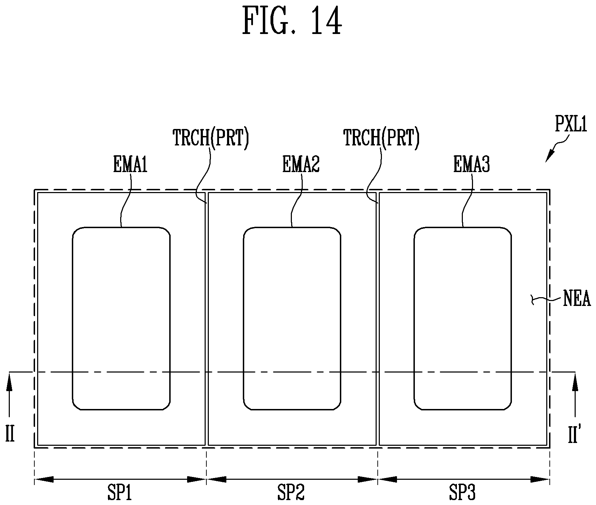

In some embodiments, the separator SPR may be provided in various forms so that the emission structure EU has a discontinuous portion in the boundary area BDA. Some other embodiments of the separator SPR will be described below with reference to FIGS. 14 to 17.

The emission structure EU may be disposed on the anode electrodes AE exposed by the openings OP of the pixel defining layer PDL. The emission structure EU may fill the opening OP of the pixel defining layer PDL, and may be completely disposed across the first to third sub-pixels SP1 to SP3.

In some embodiments, the emission structure EU may include a first emission structure EU1 (or a first stack) and a second emission structure EU2 (or a second stack), which are sequentially stacked. For example, the emission structure EU may have a tandem structure in which the first and second emission structures EU1 and EU2 are stacked. The first and second emission structures EU1 and EU2 may each emit light. The first and second emission structures EU1 and EU2 may emit light of different colors, but the present disclosure are not limited thereto. The first and second emission structures EU1 and EU2 may emit light of the same color.

In some embodiments, the first emission structure EU1 may be disconnected at the boundary area BDA by the separator SPR. For example, the first emission structure EU1 of the first sub-pixel SP1 and the first emission structure EU1 of the second sub-pixel SP2 may be disconnected or separated (e.g., may be spaced apart from each other or may be separated from each other) in the boundary area BDA. Accordingly, when the display panel DP operates, the current flowing out from each of the first to third sub-pixels SP1 to SP3 to the neighboring sub-pixel through the layers included in the emission structure EU may decrease. Accordingly, the first to third light emitting elements LD1 to LD3 may operate with relatively higher reliability. For example, the first to third light emitting elements LD1 to LD3 may operate with higher reliability with the first emission structure EU1 disconnected at the boundary area BDA than with the first emission structure EU1 being connected at (e.g., extending continuously across) the boundary area BDA.

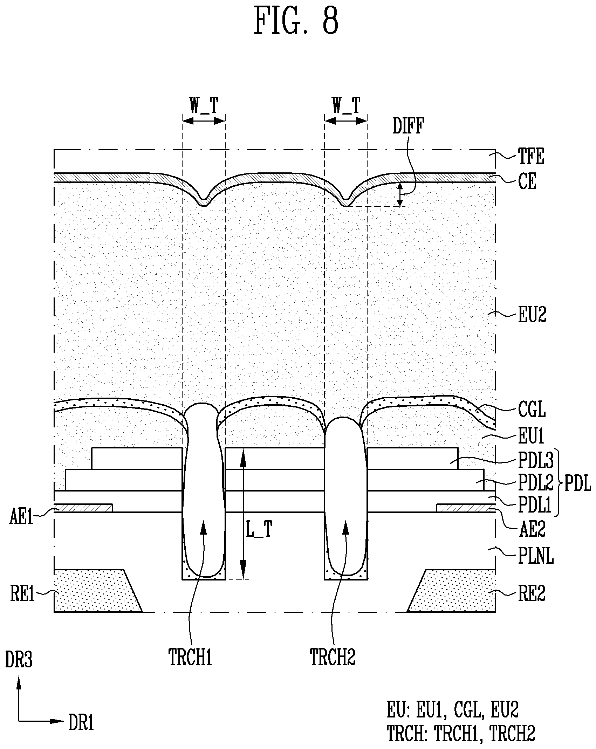

On the other hand, the second emission structure EU2 may not be disconnected in the boundary area BDA and may be continuous. For example, the second emission structure EU2 of the first sub-pixel SP1 and the second emission structure EU2 of the second sub-pixel SP2 may be connected to each other in the boundary area BDA. For example, at least a portion of the second emission structure EU2 of the first sub-pixel SP1 may extend continuously across the boundary area BDA with the second sub-pixel SP2, such that at least a portion of the second emission structure EU2 of the first sub-pixel SP1 and the second emission structure EU2 of the second sub-pixel SP2 are connected on (e.g., over) the trench. In some embodiments, a portion (e.g., a lower portion) of the second emission structure EU2 may be disconnected at the boundary area BDA, but the remaining portions of the second emission structure EU2 may be continuous (FIG. 8).

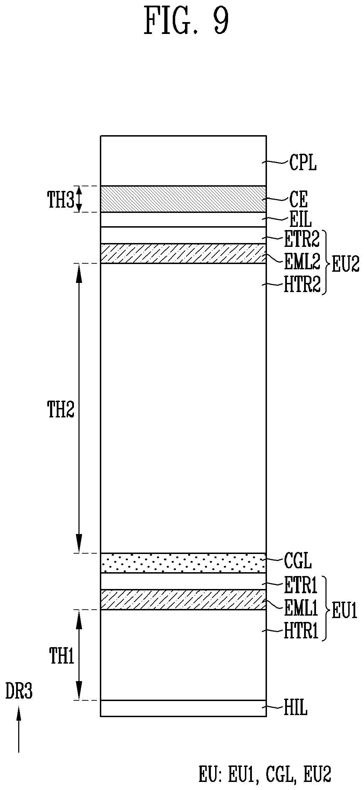

The cathode electrode CE (or the second electrode) may be disposed on the emission structure EU. The cathode electrode CE may be commonly provided to the first to third sub-pixels SP1 to SP3. The cathode electrode CE may function as a half mirror that partially transmits and partially reflects the light emitted from the emission structure EUs. In order to protect the cathode electrode CE, a capping layer including an inorganic material may be further disposed on the cathode electrode CE (see CPL of FIG. 9).

When the second emission structure EU2 is continuous in the boundary area BDA, the cathode electrode CE disposed on the second emission structure EU2 may be continuous without being disconnected in the boundary area BDA. Accordingly, the second power voltage may be stably supplied to the first to third sub-pixels SP1 to SP3, and the first to third light emitting elements LD1 to LD3 may operate normally.

The first anode electrode AE1, a portion of the emission structure EU overlapping the first anode electrode AE1, and a portion of the cathode electrode CE overlapping the first anode electrode AE1 may constitute the first light emitting element LD1. The second anode electrode AE2, a portion of the emission structure EU overlapping the second anode electrode AE2, and a portion of the cathode electrode CE overlapping the second anode electrode AE2 may constitute the second light emitting element LD2. The third anode electrode AE3, a portion of the emission structure EU overlapping the third anode electrode AE3, and a portion of the cathode electrode CE overlapping the third anode electrode AE3 may constitute the third light emitting element LD3.

The encapsulation layer TFE may be disposed on the cathode electrode CE. The encapsulation layer TFE may prevent, or reduce the occurrence of, oxygen and/or moisture from penetrating the light emitting element layer LDL.

The optical functional layer OFL may be disposed on the encapsulation layer TFE. In some embodiments, the optical functional layer OFL may be bonded to the encapsulation layer TFE through an adhesive layer APL. For example, the optical functional layer OFL may be manufactured separately and bonded to the encapsulation layer TFE through the adhesive layer APL. The adhesive layer APL may further perform the function of protecting lower layers including the encapsulation layer TFE.

The optical functional layer OFL may include a color filter layer CFL and a lens array LA. The color filter layer CFL may include first, second, and third color filters CF1, CF2, and CF3 respectively corresponding to the first, second, and third sub-pixels SP1, SP2, and SP3. The first, second, and third color filters CF1, CF2, and CF3 may pass light of different wavelength ranges. For example, the first, second, and third color filters CF1, CF2, and CF3 may transmit light of red, green, and blue colors, respectively.

In some embodiments, the first to third color filters CF1 to CF3 may partially overlap in the boundary area BDA. In some other embodiments, the first to third color filters CF1 to CF3 may be spaced apart from each other, and a black matrix may be provided between the first to third color filters CF1 to CF3.

The lens array LA may be disposed on the color filter layer CFL. The lens array LA may include first, second, and third lenses LS1, LS2, and LS3 respectively corresponding to the first, second, and third sub-pixels SP1, SP2, and SP3. The first to third lenses LS1 to LS3 may improve light output efficiency by outputting the light emitted from the first to third light emitting elements LD1 to LD3 along an intended path.

FIG. 8 is an enlarged cross-sectional view of a portion of the display device of FIG. 7, according to some embodiments of the present disclosure.

FIG. 8 illustrates the emission structure EU and the cathode electrode CE in a partial area including the first and second trenches TRCH1 and TRCH2 (e.g., the boundary area between the first sub-pixel SP1 and the second sub-pixel SP2). For clarity, the planarization layer PLNL, the pixel defining layer PDL, and the encapsulation layer TFE are further illustrated.

FIG. 9 is a cross-sectional view illustrating the emission layer included in the display device of FIG. 7, according to some embodiments of the present disclosure.

FIG. 9 further includes the cathode electrode CE.

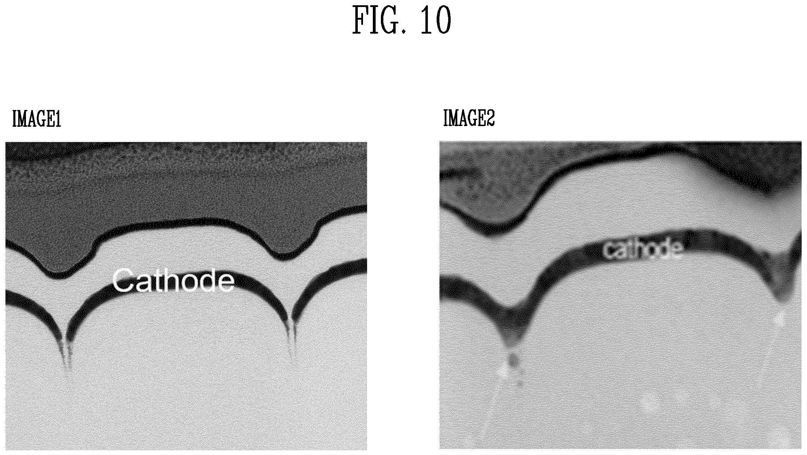

FIG. 10 is an image illustrating the display device of FIG. 8, according to some embodiments of the present disclosure.

Referring to FIGS. 7 to 9, the pixel defining layer PDL may include first, second, and third inorganic layers PDL1, PDL2, and PDL3, which are sequentially stacked on the planarization layer PLNL. The first inorganic layer PDL1 and the third inorganic layer PDL3 may each include silicon nitride (SiNₓ), and the second inorganic layer PDL2 may include silicon oxide (SiOₓ). However, the present disclosure is not limited thereto. The pixel defining layer PDL including the first, second, and third inorganic layers PDL1, PDL2, and PDL3 may have a step-shaped cross-section in the area adjacent to the opening (see OP of FIG. 7).

Because the first and second trenches TRCH1 and TRCH2 are substantially the same, the trench TRCH encompassing the first and second trenches TRCH1 and TRCH2 will be described.

Each trench TRCH may include or may be defined by a penetrated portion of the pixel defining layer PDL and a recessed portion of the planarization layer PLNL.

In some embodiments, the emission structure EU may include first and second emission structures EU1 and EU2. The emission structures EU may be configured to be substantially the same as in the first to third light emitting elements LD1 to LD3 of FIG. 7. The emission structure EU may be formed through a method such as vacuum deposition or inkjet printing, but the present disclosure is not limited thereto.

The first and second emission structures EU1 and EU2 may each include an emission layer that generates light according to an applied current. The first emission structure EU1 may include a first emission layer EML1, a 1^{st}-2 functional layer ETR1 (or a first electron transport layer), and a 1^{st}-1 functional layer HTR1 (or a first hole transport layer). The first emission layer EML1 may be disposed between the 1^{st}-2 functional layer ETR1 and the 1^{st}-1 functional layer HTR1. The second emission structure EU2 may include a second emission layer EML2, a 2^{nd}-2 functional layer ETR2 (or a second electron transport layer), and a 2^{nd}-1 functional layer HTR2 (or a second hole transport layer). The second emission layer EML2 may be disposed between the 2^{nd}-2 functional layer ETR2 and the 2^{nd}-1 functional layer HTR2.

The 1^{st}-1 and 2^{nd}-1 functional layers HTR1 and HTR2 may each include at least one of a hole injection layer or a hole transport layer, and if necessary, may further include a hole buffer layer and an electron blocking layer. The 1^{st}-1 and 2^{nd}-1 functional layers HTR1 and HTR2 may have different configurations.

The 1^{st}-2 and 2^{nd}-2 functional layers ETR1 and ETR2 may each include at least one of an electron injection layer or an electron transport layer, and if necessary, may further include an electron buffer layer and a hole blocking layer. The 1^{st}-2 and 2^{nd}-2 functional layers ETR1 and ETR2 may have the same configuration or different configurations.

In some embodiments, the first emission layer EML1 and the second emission layer EML2 may generate light of different colors. The pieces of light emitted from the first and second emission layers EML1 and EML2 may be mixed and recognized as white light. For example, the first emission layer EML1 may generate blue color light, and the second emission layer EML2 may generate yellow color light. In some embodiments, the second emission layer EML2 may include a structure in which a first sub-emission layer configured to generate red color light and a second sub-emission layer configured to generate green color light are stacked. The red color light and the green color light may be mixed to provide yellow color light. In this case, a layer configured to perform a function of transporting holes and/or blocking transport of electrons may be further disposed between the first and second sub-emission layers.

In some other embodiments, the first emission layer EML1 and the second emission layer EML2 may generate light of the same color.

An intermediate layer CGL (or a charge generation layer) may be disposed between the first emission structure EU1 and the second emission structure EU2. The intermediate layer CGL may generate charges and may connect the first emission structure EU1 to the second emission structure EU2. In some embodiments, the intermediate layer CGL may have a stacked structure of a p dopant layer and an n dopant layer. For example, the p dopant layer may include a p-type dopant such as HAT-CN, TCNQ, or NDP-9, and the n dopant layer may include an alkali metal, an alkaline earth metal, a lanthanide-based metal, or a combination thereof. However, the present disclosure is not limited thereto.

In some embodiments, as illustrated in FIG. 8, similar to the first emission structure EU1, the intermediate layer CGL may be disconnected (e.g., discontinuous) at the upper portion of the trench TRCH. For example, a first portion of the intermediate layer CGL on a first side of the trench TRCH may be disconnected from (e.g., may be spaced apart from or separated from) a second portion of the intermediate layer CGL on a second side of the trench TRCH. In this case, the occurrence of a current from flowing from one sub-pixel to another neighboring sub-pixel through the intermediate layer CGL may be reduced (e.g., may be prevented), and the sub-pixels may operate with relatively higher reliability than they would operate without the intermediate layer CGL being disconnected at the trench TRCH.

In some embodiments, based on the third direction DR3, the thickness of the first emission structure EU1 may be less than the depth L_T of the trench TRCH, and the thickness of the second emission structure EU2 may be greater than the depth L_T of the trench TRCH.

In some embodiments, the thickness of the first emission structure EU1 may be about 70% or less of the depth L_T of the trench TRCH, and the thickness of the second emission structure EU2 may be about 160% or more of the depth L_T of the trench TRCH.

In some embodiments, the ratio of the width W_T of the trench TRCH to the depth L_T of the trench TRCH may be about 1:1.45 to about 1:11. In some embodiments, the ratio of the width W_T of the trench TRCH to the depth L_T of the trench TRCH may be about 1:2.4 to about 1:3.7. For example, the ratio of the width W_T of the trench TRCH to the depth L_T of the trench TRCH may be about 1:3. For example, the depth L_T of the trench TRCH may be about 1.45 times to about 11 times the width W_T of the trench TRCH. In some embodiments, the depth L_T of the trench TRCH may be about 2.4 times to about 3.7 times the width W_T of the trench TRCH. In other words, the width W_T of the trench TRCH may be about 9% to about 70% of the depth L_T of the trench TRCH. In some embodiments, the width W_T of the trench TRCH may be about 25% to about 40% of the depth L_T of the trench TRCH.

In some embodiments, the thickness of the first emission structure EU1 may be about 19% to about 82% of the depth L_T of the trench TRCH. In some embodiments, the thickness of the first emission structure EU1 may be about 50% to about 76% of the depth L_T of the trench TRCH. For example, the thickness of the first emission structure EU1 may be about 62% of the depth L_T of the trench TRCH.

In some embodiments, the thickness of the first emission structure EU1 may be about 0.9 times to about 2.6 times the width W_T of the trench TRCH. In some embodiments, the thickness of the first emission structure EU1 may be about 1.5 to about 2.3 times the width W_T of the trench TRCH. For example, the thickness of the first emission structure EU1 may be about 1.85 times the width W_T of the trench TRCH.

In some embodiments, the thickness of the second emission structure EU2 may be about 0.5 to about 2.2 times the depth L_T of the trench TRCH. In some embodiments, the thickness of the second emission structure EU2 may be about 1.3 to about 2 times the depth L_T of the trench TRCH. For example, the thickness of the second emission structure EU2 may be about 1.63 times the depth L_T of the trench TRCH.

In some embodiments, the thickness of the second emission structure EU2 may be about 2.6 to about 6.8 times the width W_T of the trench TRCH. In some embodiments, the thickness of the second emission structure EU2 may be about 4 to about 6 times the width W_T of the trench TRCH. For example, the thickness of the second emission structure EU2 may be about 4.9 times the width W_T of the trench TRCH.

In some embodiments, the depth L_T of the trench TRCH may be about 2,500 Å to about 8,500 Å, and the width W_T of the trench TRCH may be about 800 Å to about 1,700 Å. In some embodiments, the depth L_T of the trench TRCH may be about 2,700 Å to about 3,300 Å, and the width W_T of the trench TRCH may be about 900 Å to about 1,100 Å. The thickness of the first emission structure EU1 may be within the range of about 1,650 Å to about 2,050 Å, and the thickness of the second emission structure EU2 may be within the range of about 4,500 Å to about 5,400 Å. For example, the depth L_T of the trench TRCH may be about 3,000 Å, the width W_T of the trench TRCH may be about 1,000 Å, the thickness of the first emission structure EU1 may be about 1,840 Å, and the thickness of the second emission structure EU2 may be about 4,920 Å.

For reference, the depth L_T and the width W_T of the trench TRCH and the thicknesses of the first and second emission structures EU1 and EU2 may be set considering the cutting of the intermediate layer CGL and the connection (and the resonance distance) of the cathode electrode CE. For example, when the depth L_T of each trench TRCH is greater than 8,500 Å or when the width W_T of each trench TRCH is greater than 1,700 Å, the cathode electrode CE may be disconnected at the upper portion of the trench TRCH and the sub-pixels may not emit light, like the first image IMAGE1 illustrated in FIG. 10. For example, when the depth L_T of each trench TRCH is less than 2,500 Å or when the width W_T of each trench TRCH is less than 800 Å, the intermediate layer CGL may be connected at the upper portion of the trench TRCH without being separated, and side leakage may occur through the intermediate layer CGL. When the depth L_T of each trench TRCH is about 3,000 Å and the width W_T of each trench TRCH is about 1,000 Å, the cathode electrode CE may be connected at the upper portion of the trench TRCH like the second image IMAGE2 illustrated in FIG. 10, but the intermediate layer CGL may be separated from the upper portion of the trench TRCH.

In some embodiments, based on the third direction DR3, the thickness TH1 of the 1^{st}-1 functional layer HTR1 (or the first hole transport layer) may be less than the depth L_T of the trench TRCH, and the thickness TH2 of the 2^{nd}-1 functional layer HTR2 (or the second hole transport layer) may be greater than the depth L_T of the trench TRCH.

In some embodiments, the thickness TH2 of the 2^{nd}-1 functional layer HTR2 (or the second hole transport layer) may be about 0.4 times to about 1.8 times the depth L_T of the trench TRCH. In some embodiments, the thickness TH2 of the 2^{nd}-1 functional layer HTR2 (or the second hole transport layer) may be about 1 time to about 1.7 times the depth L_T of the trench TRCH. For example, the thickness TH2 of the 2^{nd}-1 functional layer HTR2 (or the second hole transport layer) may be about 1.33 times the depth L_T of the trench TRCH.

In some embodiments, the thickness TH2 of the 2^{nd}-1 functional layer HTR2 (or the second hole transport layer) may be about 2 times to about 5.5 times the width W_T of the trench TRCH. In some embodiments, the thickness TH2 of the 2^{nd}-1 functional layer HTR2 (or the second hole transport layer) may be about 3.2 times to about 4.8 times the width W_T of the trench TRCH. For example, the thickness TH2 of the 2^{nd}-1 functional layer HTR2 (or the second hole transport layer) may be about 4 times the width W_T of the trench TRCH.

In some embodiments, when the depth L_T of the trench TRCH is about 3,000 Å and the width W_T of the trench TRCH is within the range of about 800 Å to about 1,700 Å, the thickness TH1 of the 1^{st}-1 functional layer HTR1 (or first hole transport layer) is within the range of about 1,200 Å to about 1,650 Å, and the thickness TH2 of the 2^{nd}-1 functional layer HTR2 (or the second hole transport layer) may be within the range of about 3,600 Å to about 4,400 Å. For example, the thickness TH1 of the 1^{st}-1 functional layer HTR1 (or the first hole transport layer) is about 1,350 Å, the thickness TH2 of the 2^{nd}-1 functional layer HTR2 (or the second hole transport layer) may be about 4,000 Å.

For reference, the thickness of the first emission layer EML1 may be about 170 Å to about 210 Å (e.g., about 190 Å), the thickness of the 1^{st}-2 functional layer ETR1 may be about 90 Å to about 110 Å (e.g., about 100 Å), the thickness of the intermediate layer CGL may be about 160 Å to about 195 Å (e.g., about 175 Å), the thickness of the second emission layer EML2 may be about 360 Å to about 440 Å (e.g., about 400 Å), and the thickness of the 2^{nd}-2 functional layer ETR2 may be about 230 Å to about 290 Å (e.g., about 260 Å).

When the thickness TH1 of the 1^{st}-1 functional layer HTR1 is less than the depth L_T of the trench TRCH, the intermediate layer CGL (and the first emission structure EU1) may be stably cut at the upper portion of the trench TRCH. When the thickness TH2 of the 2^{nd}-1 functional layer HTR2 is greater than the depth L_T of the trench TRCH, the second emission structure EU2 (and the cathode electrode CE) may be stably connected at the upper portion of the trench TRCH. In some embodiments, when the thickness TH1 of the 1^{st}-1 functional layer HTR1 is about 1,200 Å to about 1,650 Å and the thickness TH2 of the 2^{nd}-1 functional layer HTR2 is about 3,600 Å to about 4,400 Å, (based on the first emission structure EU1 having a thickness of about 1,650 Å to about 2,050 Å and the second emission structure EU2 having a thickness of about 4,500 Å to about 5,400 Å), holes and electrons recombining in each of the first and second emission layers EML1 and EML2 may be balanced, and thus, the luminance efficiency of the first and second emission structures EU1 and EU2 may be maximized. Furthermore, when the thickness TH1 of the 1^{st}-1 functional layer HTR1 is about 1,200 Å to about 1,650 Å and the thickness TH2 of the 2^{nd}-1 functional layer HTR2 is about 3,600 Å to about 4,400 Å, the resonance distance of light emitted from the first and second emission layers EML1 and EML2 (e.g., the distance in which light is emitted from each of the first and second emission layers EML1 and EML2 and travels back and forth between the reflective electrodes RE1 and RE2 and the cathode electrode CE) may be optimized, and thus, the light generated in the first and second emission layers EML1 and EML2 may be amplified and output through the cathode electrode CE.

In some embodiments, the 1^{st}-1 functional layer HTR1 and the 2^{nd}-1 functional layer HTR2 may include different materials. For example, each of the 1^{st}-1 functional layer HTR1 and the 2^{nd}-1 functional layer HTR2 may each include a general material constituting the hole transport layer of the organic light emitting diode (e.g., an organic conductive material including carbon and hydrogen), and the 1^{st}-1 functional layer HTR1 and the 2^{nd}-1 functional layer HTR2 may include materials with different structures.

In some embodiments, the 1^{st}-1 functional layer HTR1 (or the first hole transport layer) may include a plate-type material (or a material with a plate-type structure), and the 2^{nd}-1 functional layer HTR2 (or the second hole transport layer) may include a relatively bulky material (hereinafter referred to as a "bulk material") (or a material with a bulk structure), compared to the plate-type material. The plate-type may refer to a structure in which atoms are arranged in two dimensions or atomic layer thickness, or a structure in which materials are stacked in the form of a thin and flat plate. For example, the plate type material may have a high specific surface area and strong bond, but may have low compressive or tensile strength. The bulk type may refer to a structure in which a material exists in the form of a large and thick lump, or a structure in which atoms are arranged in three dimensions and the atomic arrangement on the surface matches the atomic arrangement in the bulk. In other words, the bulk type may be a structure in which solid misalignment is minimized when forming the surface. In other words, the bulk type has characteristics that the spacing between atoms is constant and the spacing is the same for each layer. The bulk type may have a low specific surface area and may be strong and rigid, but may have low flexibility or bonding strength.

Hereinafter, characteristics (or physical properties, e.g., Tg, Td, HOMO, LUMO, reflective index) of the plate-type material and the bulk material will be described. Hereinafter, "Tg" (hereinafter referred to as "thermal property (Tg)") refers to glass transition temperature, which is a temperature at which a polymer transitions from a glass state to a polymer body. The thermal property (Tg) may be measured by using a thermal analyzer or a differential scanning calorimetry (DSC), which is an analysis technology that measures the amount of heat released or absorbed when a sample is heated or cooled in a specific temperature range. "Td" refers to a temperature at which a material (or sample) decomposes. "Td(1%)" (hereinafter referred to as "thermal property Td(1%)") is a temperature when the weight is reduced by 1% compared to the initial weight, and "Td(5%)" (hereinafter referred to as "thermal property Td(5%)") is a temperature when the weight is reduced by 1% compared to the initial weight. "Td" may be measured through thermogravimetric analysis (TGA). A highest occupied molecular orbital (HOMO) and a lowest unoccupied molecular orbital (LUMO) are molecular orbitals that represent the electronic structure of the molecule. The HOMO refers to a molecular orbital in the highest energy region in which electrons may participate in bonding, and the LUMO refers to a molecular orbital in which electrons are located in the lowest energy region of the antibonding region.

The thermal property (Tg) (or the glass transition temperature) of the plate-type material may be about 120 degrees Celsius (°C) to about 130 °C, and the thermal property (Tg) of the bulk material may be about 145 °C to about 155 °C. For example, the thermal property (Tg) of the bulk material may be higher than the thermal property (Tg) of the plate-type material by about 15 °C to about 35 °C, or by about 10% to about 30%. As the thermal property (Tg) (or the glass transition temperature) is lower, deformation may occur more easily.

The thermal property (Td(1%)) of the plate-type material may be about 320 °C to about 335 °C, and the thermal property (Td(1%)) of the bulk material may be about 340 °C to about 365 °C. For example, the thermal property (Td(1%)) of the bulk material may be higher than the thermal property (Td(1%)) of the plate-type material by about 5 °C to about 45 °C, or by about 1.5% to about 15%.

The thermal property (Td(5%)) of the plate-type material may be about 340 °C to about 365 °C, and the thermal property (Td(5%)) of the bulk material may be about 385 °C to about 405 °C. For example, the thermal property (Td(5%)) of the bulk material may be higher than the thermal property (Td(5%)) of the plate-type material by about 20 °C to about 65 °C, or by about 5% to about 20%.

The energy of the HOMO molecular orbital of the plate-type material may be about 5.3 eV to about 5.7 eV, and the energy of the HOMO molecular orbital of the bulk material may be about -5.4 eV to about -4.6 eV. For example, the energy of the HOMO molecular orbital of the bulk material may be lower than the energy of the HOMO molecular orbital of the plate-type material by about 9.9 eV to about 11.1 eV, or about 173% to about 210%.

The energy of the LUMO molecular orbital of the plate-type material may be about 2.2 eV to about 2.6 eV, and the energy of the LUMO molecular orbital of the bulk material may be about -2.2 eV to about -0.8 eV. For example, the energy of the LUMO molecular orbital of the bulk material may be higher than the energy of the LUMO molecular orbital of the plate-type material by about 3.0 eV to about 4.8 eV, or by about 115% to about 220%.

The refractive index of the plate-type material may be about 1.7 to about 1.9, or about 1.77 to about 1.89, and the refractive index of the bulk material may be about 1.6 to about 1.8, or about 1.7 to about 1.76. For example, the refractive index of the bulk material may be less than the refractive index of the plate-type material.

In some embodiments, the molecular shape (or geometry optimization) of the plate-type material may be flat, the Van Der Waals force (or bonding force) of the plate-type material may be about 405 to about 497, the angle of the plate-type material may be about 198 to about 204, and the torsion (or torsion force) of the plate-type material may be about 446 to about 546. The Van Der Waals refers to the intermolecular attraction force (unit: kJ/mol), the angle refers to an angle between two bonds in the molecule (unit: radian), and the torsion refers to rotation inside the molecule (unit: radian). In some embodiments, the molecular shape of the bulk material may be twisted, the Van Der Waals of the bulk material may be about 710 to about 866, the angle of the bulk material may be about 1221 to about 1491, and the twist of the bulk material may be about 659 to about 805. The Van Der Waals, the angle, and the twist of the bulk material may be greater than the Van Der Waals, the angle, and the twist of the plate-type material, respectively.

The plate-type material has a flat molecular shape and is thus deposited regularly. However, because the Van Der Waals (or Van Der Waals force) of the plate-type material is small, the plate-type material (or the plate-type material layer) may be greatly affected by the underlying layer (e.g., void). The bulk material has a large angle and twist and is thus deposited in a twisted form, and the bulk material (or the bulk material layer) may be less affected by the underlying layer (e.g., void). In some embodiments, because the Van Der Waals of the bulk material is large, the bulk material (or the bulk material layer) may cover the lower layer like a net and maintain the shape thereof, even in a scattered deposited state, regardless of the shape (e.g., void) of the lower layer.

Because of the flat shape of the plate-type material, the plate-type material may have a bond concentrated in the center of the lattice. For example, the plate-type material may have the shape of stacked bricks. The bulk material may spread out like a net within the lattice due to the twisted form thereof. Because the Van Der Waals of the bulk material is large, the bulk material may maintain the net shape thereof. When checking the lattice density, the bulk material may spread out more widely than the plate-type material, and the probability that the bulk material covers a specific lower layer structure (e.g., void) may be greater.

In some embodiments, the plate-type material may include a p dopant. In this case, the Van Der Waals of the plate-type material may be about 349 to about 425, and the angle of the plate-type material may be about 191 to about 233. On the other hand, the bulk material may not include a p dopant.

When the 1^{st}-1 functional layer HTR1 including the plate-type material is formed on the trench TRCH, the 1^{st}-1 functional layer HTR1 may be bent and disconnected in the trench TRCH. Accordingly, the first emission structure EU1 including the 1^{st}-1 functional layer HTR1 and the relatively thin intermediate layer CGL may be disconnected in the trench TRCH. In contrast, when the 1^{st}-1 functional layer HTR1 includes the bulk material, the 1^{st}-1 functional layer HTR1 may not be disconnected in the trench TRCH, and thus, the intermediate layer CGL may be connected at the trench TRCH and side leakage may occur. On the other hand, when the 2^{nd}-1 functional layer HTR2 including the bulk material is formed on the trench TRCH, the 2^{nd}-1 functional layer HTR2 may be connected to the trench TRCH without being bent. Accordingly, the second emission structure EU2 including the 2^{nd}-1 functional layer HTR2 may not be disconnected in the trench TRCH. In some embodiments, a large step may not be formed on the upper surface of the second emission structure EU2 including the 2^{nd}-1 functional layer HTR2, and thus, the cathode electrode CE may not be disconnected. In contrast, when the 2^{nd}-1 functional layer HTR2 includes the plate-type material, the 2^{nd}-1 functional layer HTR2 may be disconnected in the trench TRCH, and thus, the cathode electrode CE may also be disconnected in the trench TRCH.

In some embodiments, the thickness TH3 of the cathode electrode CE may be within the range of about 100 Å to about 190 Å, or within the range of about 150 Å to about 185 Å. Additionally, a step (e.g., a step difference DIFF) of the cathode electrode CE at the upper portion (e.g., on or above the upper portion) of the trench TRCH may be about 500 Å or less. As the thickness TH3 of the cathode electrode CE increases, the cathode electrode CE may be more stably connected to the trench TRCH, but the light transmission efficiency of the cathode electrode CE may decrease. When the second emission structure EU2 (or the 2^{nd}-1 functional layer HTR2) is connected without being bent in the trench TRCH, the step of the curved portion of the upper surface of the second emission structure EU2 may be reduced to about 500 Å or less, and the cathode electrode CE may be connected without being disconnected at the upper portion of the trench TRCH with only a thickness of about 150 Å to about 185 Å (e.g., about 170 Å).

As described above, the thickness of the first emission transport region HTR1 (or the first emission structure EU1) may be less than the depth L_T of the trench TRCH, and the thickness of the second emission transport region HTR2 (or the second emission structure EU2) may be greater than the depth L_T of the trench TRCH. In some embodiments, the 1^{st}-1 functional layer HTR1 (or the first hole transport layer) may include a plate-type material, and the 2^{nd}-1 functional layer HTR2 (or the second hole transport layer) may include a bulk material. In this case, in the upper portion of the trench TRCH, the first emission structure EU1 and the intermediate layer CGL may be disconnected to prevent, or reduce the occurrence of, side leakage, and the second emission structure EU2 and the cathode electrode CE may be connected so that the sub-pixels are driven normally. For example, the sub-pixels may accurately emit light at a desired luminance, and display quality may be improved.

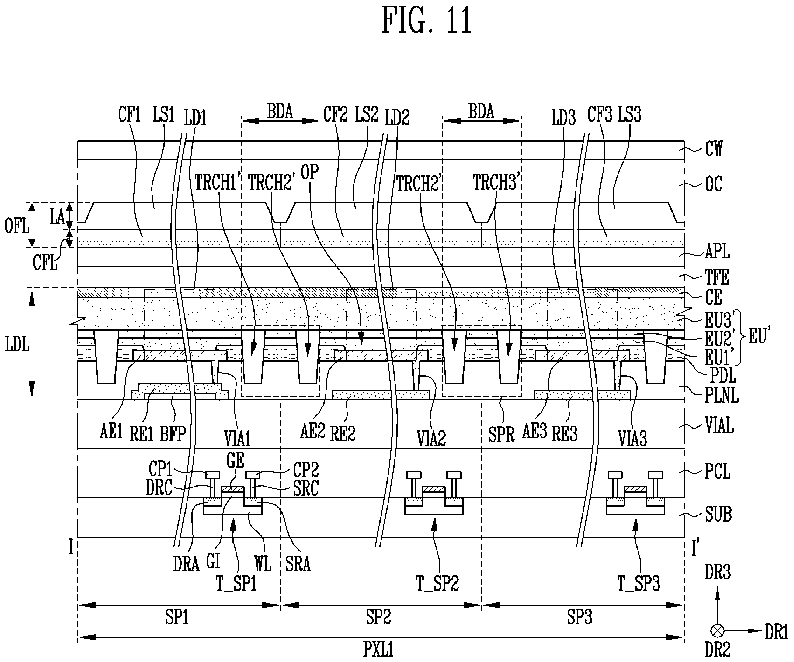

FIG. 11 is a cross-sectional view illustrating another embodiment of the display device taken along the line I-I' of FIG. 6A, according to some embodiments of the present disclosure.

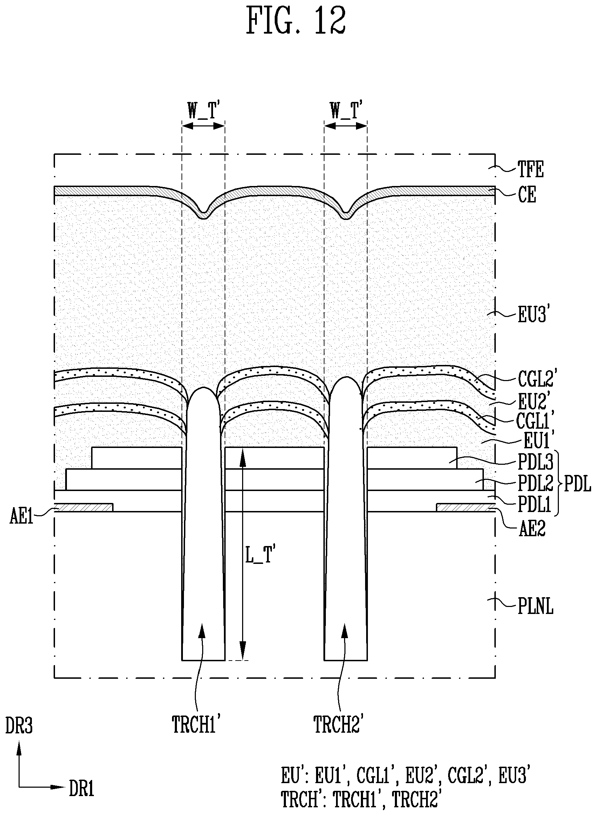

FIG. 12 is an enlarged cross-sectional view of a portion of the display device of FIG. 11, according to some embodiments of the present disclosure.

FIG. 12 illustrates an emission structure EU' and a cathode electrode CE in a partial area including first and second trenches TRCH1' and TRCH2' (e.g., a boundary area between a first sub-pixel SP1 and a second sub-pixel SP2).

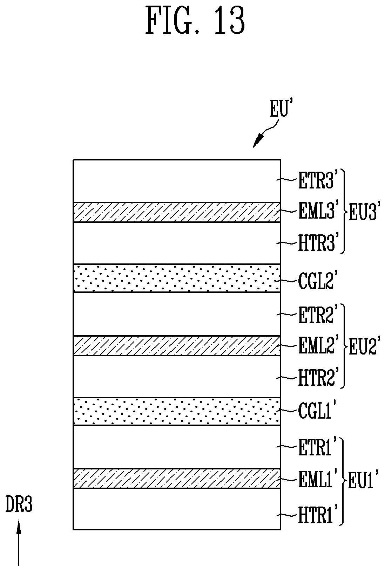

FIG. 13 is a cross-sectional view illustrating an emission layer included in the display device of FIG. 11, according to some embodiments of the present disclosure.

Referring to FIGS. 7 to 13, the display device of FIG. 11 may be substantially the same as or similar to the display device of FIGS. 7 and 8, except for an emission structure EU'. Therefore, redundant descriptions will not be repeated.

The emission structure EU' may have a tandem structure in which first, second, and third emission structures EU1', EU2', and EU3' are stacked. The emission structure EU' may be configured to be substantially the same as in the first to third light emitting elements LD1 to LD3 of FIG. 11.

As illustrated in FIG. 11, the first emission structure EU1' and the second emission structure EU2' may be disconnected at a boundary area BDA by a separator SPR (e.g., trenches TRCH1 to TRCH3). For example, the first and second emission structures EU1' and EU2' of the first sub-pixel SP1 and the first and second emission structures EU1' and EU2' of the second sub-pixel SP2 may be disconnected or separated in the boundary area BDA. Accordingly, when the display panel DP operates, the current flowing out from each of the first to third sub-pixels SP1 to SP3 to the neighboring sub-pixel through the layers included in the emission structure EU' may decrease.

On the other hand, the third emission structure EU3' may not be disconnected in the boundary area BDA and may be continuous. For example, the third emission structure EU3' of the first sub-pixel SP1 and the third emission structure EU3' of the second sub-pixel SP2 may be connected to each other in the boundary area BDA.

The first to third emission structures EU1' to EU3' may each include an emission layer that generates light according to an applied current. The first emission structure EU1' may include a first emission layer EML 1', a 1^{st}-2 functional layer ETR1', and a 1^{st}-1 functional layer HTR1'. The first emission layer EML1' may be disposed between the 1^{st}-2 functional layer ETR1' and the 1^{st}-1 functional layer HTR1'. The second emission structure EU2' may include a second emission layer EML2', a 2^{nd}-2 functional layer ETR2', and a 2^{nd}-1 functional layer HTR2'. The second emission layer EML2' may be disposed between the 2^{nd}-2 functional layer ETR2' and the 2^{nd}-1 functional layer HTR2'. The third emission structure EU3' may include a third emission layer EML3', a 3^{rd}-2 functional layer ETR3', and a 3^{rd}-1 functional layer HTR3'. The third emission layer EML3' may be disposed between the 3^{rd}-2 functional layer ETR3' and the 3^{rd}-1 functional layer HTR3'.

The 1^{st}-1, 2^{nd}-1, and 3^{rd}-1 functional layers HTR1', HTR2', and HTR3' may each include at least one of a hole injection layer or a hole transport layer, and if necessary, may further include a hole buffer layer and an electron blocking layer. Some of the 1^{st}-1, 2^{nd}-1, and 3^{rd}-1 functional layers HTR1', HTR2', and HTR3' may have different configurations.

The 1^{st}-2, 2^{nd}-2, and 3^{rd}-2 functional layers ETR1', ETR2', and ETR3' may each include at least one of an electron injection layer or an electron transport layer, and if necessary, may further include an electron buffer layer or a hole blocking layer. The 1^{st}-2, 2^{nd}-2, and 3^{rd}-2 functional layers ETR1', ETR2', and ETR3' may have the same or configurations different configurations.

In some embodiments, the first to third emission layers EML1' to EML3' may generate light of different colors. The pieces of light emitted from the first to third emission layers EML1' to EML3' may be mixed and recognized as white light. For example, the first emission layer EML1' may generate blue color light, the second emission layer EML2' may generate green color light, and the third emission layer EML3' may generate red color light.

In some other embodiments, two or more of the first to third emission layers EML1' to EML3' may generate light of the same color.

A first intermediate layer CGL1' (or a first charge generation layer) may be disposed between the first emission structure EU1' and the second emission structure EU2'. A second intermediate layer CGL2' (or a second charge generation layer) may be disposed between the second emission structure EU2' and the third emission structure EU3'.

In some embodiments, as illustrated in FIG. 12, similar to the first and second emission structures EU1' and EU2', the first and second intermediate layers CGL1' and CGL2' may be disconnected at the upper portions of the trenches TRCH1 to TRCH3. In this case, the occurrence of a current flowing from the sub-pixel to another neighboring sub-pixel through the first and second intermediate layers CGL1' and CGL2' may be reduced (e.g., may be prevented), and the sub-pixel may operate with high reliability.

In some embodiments, the ratio of the width W_T' to the depth L_T' of the trench TRCH' may be about 1:1.45 to about 1:11. In some embodiments, the ratio of the width W_T' to the depth L_T' of the trench TRCH' may be about 1:4.2 to about 1:6.4. For example, the ratio of the width W_T' to the depth L_T' of the trench TRCH' may be about 1:5.2. In other words, the width W_T' of the trench TRCH' may be about 9% to about 70% of the depth L_T' of the trench TRCH'. In some embodiments, the width W_T' of the trench TRCH' may be about 15% to about 24% of the depth L_T' of the trench TRCH'.

The total thickness of the first and second emission structures EU1' and EU2' may be similar to the thickness of the first emission structure EU1 in FIG. 9, and the thickness of the third emission structure EU3' may be similar to the thickness of the second emission structure EU2 of FIG. 9.

In some embodiments, the total thickness of the first emission structures EU1' and EU2' may be about 17% to about 82% of the depth L_T' of the trench TRCH'. In some embodiments, the total thickness of the first and second emission structures EU1' and EU2' may be about 51% to about 78% of the depth L_T' of the trench TRCH'. For example, the total thickness of the first and second emission structures EU1' and EU2' may be about 63% of the depth L_T' of the trench TRCH'.

In some embodiments, the total thickness of the first emission structures EU1' and EU2' may be about 0.8 times to about 2.6 times the width L_T' of the trench TRCH'. In some embodiments, the total thickness of the first and second emission structures EU1' and EU2' may be about 1.2 to about 1.8 times the width W_T' of the trench TRCH'. For example, the total thickness of the first and second emission structures EU1' and EU2' may be about 1.53 times the width L_T' of the trench TRCH'.

In some embodiments, the thickness of the third emission structure EU3' may be about 0.4 times to about 2.5 times the depth L_T' of the trench TRCH'. In some embodiments, the thickness of the third emission structure EU3' may be about 0.6 times to about 1.0 times the depth L_T' of the trench TRCH'. For example, the thickness of the third emission structure EU3' may be about 0.78 times the depth L_T' of the trench TRCH'.

In some embodiments, the thickness of the third emission structure EU3' may be about 2.4 to about 6.5 times the width W_T' of the trench TRCH'. In some embodiments, the thickness of the third emission structure EU3' may be about 3.3 to about 5.0 times the width W_T' of the trench TRCH'. For example, the thickness of the third emission structure EU3' may be about 4.1 times the width W_T of the trench TRCH.

In some embodiments, the depth L_T' of the trench TRCH' may be about 2,500 Å to about 8,500 Å, and the width W_T' of the trench TRCH' may be about 800 Å to about 1,700 Å. In some embodiments, the depth L_T' of the trench TRCH' may be about 5,400 Å to about 6,800 Å, and the width W_T' of the trench TRCH' may be about 1,035 Å to about 1,265 Å. The thickness of the first emission structure EU1' may be within the range of about 900 Å to about 1,100 Å, the thickness of the second emission structure EU2' may be within the range of about 531 Å to about 649 Å, and the thickness of the third emission structure EU3' may be within the range of about 4,312 Å to about 5,148 Å. For example, the depth L_T' of the trench TRCH' may be about 6,000 Å, the width W_T' of the trench TRCH' may be about 1,150 Å, the thickness of the first emission structure EU1' may be about 1,000 Å, the thickness of the second emission structure EU2' may be about 590 Å, and the thickness of the third emission structure EU3' may be about 4,680 Å. The thickness of the 3^{rd}-1 functional layer HTR3' may be similar to the thickness TH2 of the 2^{nd}-1 functional layer HTR2 in FIG. 9.

In some embodiments, the thickness of the 3^{rd}-1 functional layer HTR3' (or the third hole transport layer) may be about 0.4 times to about 1.8 times the depth L_T' of the trench TRCH'. In some embodiments, the thickness of the 3^{rd}-1 functional layer HTR3' (or the third hole transport layer) may be about 0.5 times to about 0.8 times the depth L_T' of the trench TRCH'. For example, the thickness of the 3^{rd}-1 functional layer HTR3' (or the third hole transport layer) may be about 0.63 times the depth L_T' of the trench TRCH'.

In some embodiments, the thickness of the 3^{rd}-1 functional layer HTR3' (or the third hole transport layer) may be about 2 times to about 5.5 times the width W_T' of the trench TRCH'. In some embodiments, the thickness of the 3^{rd}-1 functional layer HTR3' (or the third hole transport layer) may be about 2.7 times to about 4.1 times the width W_T' of the trench TRCH'. For example, the thickness of the 3^{rd}-1 functional layer HTR3' (or the third hole transport layer) may be about 3.3 times the width W_T' of the trench TRCH'.

In some embodiments, when the depth L_T' of the trench TRCH' is about 6,000 Å and the width W_T' of the trench TRCH' is within the range of about 800 Å to about 1,700 Å, the thickness of the 1^{st}-1 functional layer HTR1' (or the first hole transport layer) may be within the range of about 225 Å to about 275 Å, the thickness of the 2^{nd}-1 functional layer HTR2' (or the second hole transport layer) may be within the range of about 180 Å to about 220 Å, and the thickness of the 3^{rd}-1 functional layer HTR3' (or the third hole transport layer) may be within the range of about 3,411 Å to about 4,169 Å. For example, the thickness of the 1^{st}-1 functional layer HTR1' (or the first hole transport layer) may be about 250 Å, the thickness of the 2^{nd}-1 functional layer HTR2' (or the second hole transport layer) may be about 200 Å, and the thickness of the 3^{rd}-1 functional layer HTR3' (or the third hole transport layer) may be about 3,790 Å.

For reference, the thickness of the first emission layer EML1' may be about 400 Å to about 500 Å (e.g., about 450 Å), the thickness of the 1^{st}-2 functional layer ETR1' may be about 130 Å to about 170 Å (e.g., about 150 Å), the thickness of the first intermediate layer CGL1' may be about 160 Å to about 195 Å (e.g., about 175 Å), the thickness of the second emission layer EML2' may be about 170 Å to about 210 Å (e.g., about 190 Å), the thickness of the 2^{nd}-2 functional layer ETR2' may be about 130 Å to about 170 Å (e.g., about 150 Å), the thickness of the second intermediate layer CGL2' may be about 160 Å to about 195 Å (e.g., about 175 Å), the thickness of the third emission layer EML3' may be about 290 Å to about 370 Å (e.g., about 330 Å), and the thickness of the 3^{rd}-2 functional layer ETR3' may be about 280 Å to about 360 Å (e.g., about 320 Å).

In some embodiments, the 1^{st}-1 and 2^{nd}-1 functional layers HTR1' and HTR2' (or the first and second hole transport layers) include a plate-type material, and the 3^{rd}-1 functional layer HTR3' (or third hole transport layer) may include a bulk material. In this case, the first emission structure EU1', the first intermediate layer CGL1', the second emission structure EU2', and the second intermediate layer CGL2' may be disconnected in the trenches TRCH1' to TRCH3', and the third emission structure EU3' and the cathode electrode CE may not be disconnected in the trenches TRCH1' to TRCH3'.

The occurrence of side leakage may be reduced (e.g., may be prevented) by cutting the first and second intermediate layers CGL1' and CGL2', and the sub-pixels may be driven normally by the connection of the cathode electrode CE.

FIG. 14 is a plan view illustrating the pixel included in the display device of FIG. 5, according to some embodiments of the present disclosure.

FIG. 15 is a cross-sectional view taken along line II-II' illustrating the display device of FIG. 14, according to some embodiments of the present disclosure.

Referring to FIGS. 6A, 7, 14, and 15, the display devices of FIGS. 14 and 15 may be substantially the same as or similar to the display devices of FIGS. 6A and 7, except for a trench TRCH (or a separator SPR). Therefore, redundant descriptions will not be repeated.

A separator SPR may be provided in a boundary area BDA between neighboring sub-pixels.

In some embodiments, the pixel defining layer PDL may include one trench TRCH as the separator SPR in the boundary area BDA. For example, as illustrated in FIGS. 14 and 15, one trench TRCH may be provided as the separator SPR in the boundary area BDA between the first sub-pixel SP1 and the second sub-pixel SP2 and in the boundary area BDA between the second sub-pixel SP2 and the third sub-pixel SP3.

As illustrated in FIG. 14, one trench TRCH may surround each of the first to third sub-pixels SP1 to SP3. The trench TRCH may have a grid corresponding to the sub-pixel. For example, the trench TRCH may have a mesh structure.

In some embodiments, the trench TRCH may penetrate the pixel defining layer PDL and partially penetrate the planarization layer PLNL. However, the present disclosure is not limited thereto. In some embodiments, the pixel defining layer PDL may not be disposed in the trench TRCH. However, the present disclosure is not limited thereto. For example, the pixel defining layer PDL may be disposed on the side and bottom surfaces of the trench TRCH, so that the trench TRCH is defined by the pixel defining layer PDL.

Because the specifications (e.g., depth, width, and/or the like) of the trench TRCH have been described with reference to FIG. 8, descriptions of the specifications of the trench TRCH will not be provided.

The first emission structure EU1 may be disconnected in the boundary area BDA by the separator SPR. Accordingly, when the display panel DP operates, the current flowing out from each of the first to third sub-pixels SP1 to SP3 to the neighboring sub-pixel through the layers included in the emission structure EU may decrease.

On the other hand, the second emission structure EU2 may not be disconnected in the boundary area BDA and may be continuous. In this case, the cathode electrode CE may not be disconnected in the boundary area BDA and may be continuous. Accordingly, the second power voltage may be stably supplied to the first to third sub-pixels SP1 to SP3, and the first to third light emitting elements LD1 to LD3 may operate normally.

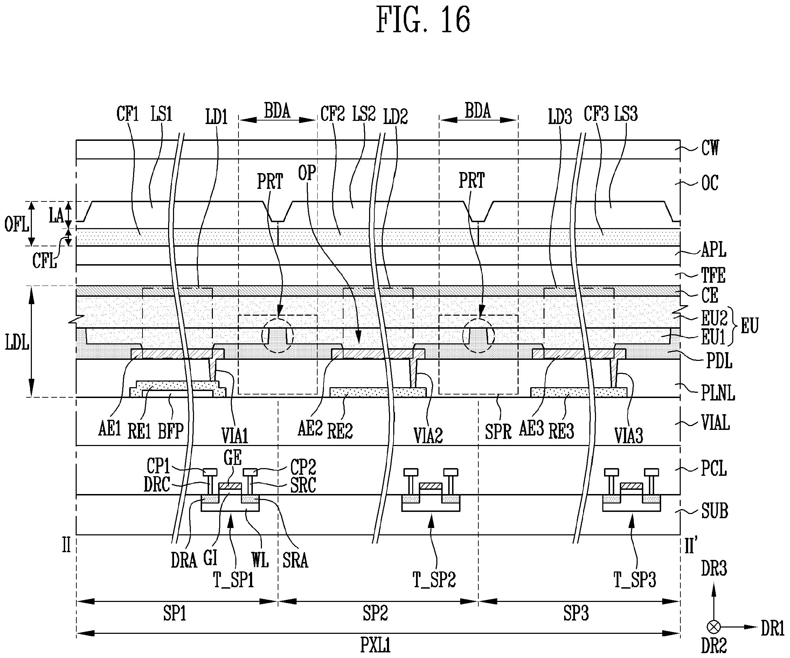

FIG. 16 is a cross-sectional view taken along line II-II' illustrating the display device of FIG. 14, according to some embodiments of the present disclosure.

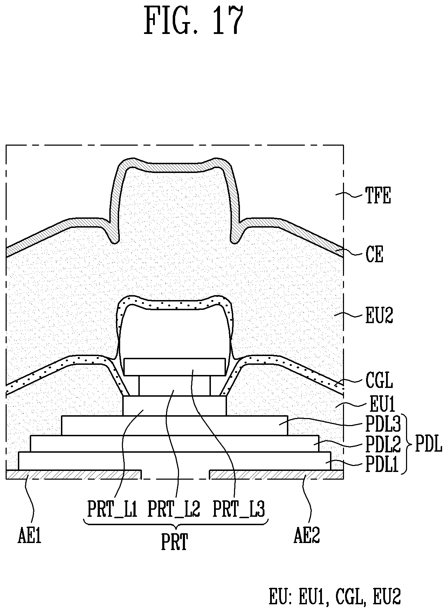

FIG. 17 is an enlarged cross-sectional view of a portion of the display device of FIG. 16, according to some embodiments of the present disclosure.

Referring to FIGS. 7, 8, 14, 16, and 17, the display devices of FIGS. 16 and 17 may be substantially the same as or similar to the display devices of FIGS. 7 and 8, except that protrusions PRT are provided as the separators SPR, instead of the trenches. Therefore, redundant descriptions will not be repeated.

In some embodiments, the pixel defining layer PDL may include a protrusion PRT that protrudes from the boundary area BDA in the third direction DR3. The protrusion PRT may form a step in the base layer (i.e., the upper surface of the pixel defining layer PDL) for arrangement of the first emission structure EU1 in the boundary area BDA, and may disconnect the first emission structure EU1 (and the intermediate layer CGL) in the boundary area BDA.

The protrusion PRT may include inorganic insulating patterns that are sequentially stacked. As described with reference to FIG. 8, the pixel defining layer PDL may include first, second, and third inorganic layers PDL1, PDL2, and PDL3 that are sequentially stacked. The protrusion PRT may include first, second, and third inorganic insulating patterns PRT_L1, PRT_L2, and PRT_L3 (or fourth, fifth, and sixth inorganic patterns) that are sequentially stacked on the third inorganic layer PDL3. The first inorganic insulating pattern PRT_L1 and the third inorganic insulating pattern PRT_L3 may each include silicon oxide (SiOₓ), and the second inorganic insulating pattern PRT_L2 may include silicon nitride (SiNₓ).

In some embodiments, based on the first direction DR1, the width of the third inorganic insulating pattern PRT_L3 may be greater than the width of the second inorganic insulating pattern PRT_L2. In some embodiments, the width of the second inorganic insulating pattern PRT_L2 may be less than or equal to the width of the first inorganic insulating pattern PRT_L1. In this case, the protrusion PRT may have a cross-section of an inverse tapered shape, a "T" shape, or an "I" shape.

The first emission structure EU1 and the intermediate layer CGL may be disconnected in the boundary area BDA according to the shape of the protrusion PRT (or the pixel defining layer PDL). On the other hand, the second emission structure EU2 and the cathode electrode CE may be connected to each other in the boundary area BDA without being disconnected.

As illustrated in FIG. 17, the first emission structure EU1 and the intermediate layer CGL may not be formed (or deposited) on the side of the protrusion PRT, and the first emission structure EU1 and the intermediate layer CGL may be disconnected at the edge of the protrusion PRT.

In some embodiments, based on the third direction DR3, the thickness of the first emission structure EU1 may be less than the thickness of the protrusion PRT, and the thickness of the second emission structure EU2 may be greater than the thickness of the protrusion PRT. In this case, at the edge of the protrusion PRT, each of the first emission structure EU1 and the intermediate layer CGL may be disconnected or discontinuous, and each of the second emission structure EU2 and the cathode electrode CE may be connected or continuous.

As described with reference to FIG. 9, the first emission structure EU1 may include a first emission layer EML1, a 1^{st}-2 functional layer ETR1 (or a first electron transport layer), and a 1^{st}-1 functional layer HTR1 (or a first hole transport layer). The first emission layer EML1 may be disposed between the 1^{st}-2 functional layer ETR1 and the 1^{st}-1 functional layer HTR1. The second emission structure EU2 may include a second emission layer EML2, a 2^{nd}-2 functional layer ETR2 (or a second electron transport layer), and a 2^{nd}-1 functional layer HTR2 (or a second hole transport layer). The second emission layer EML2 may be disposed between the 2^{nd}-2 functional layer ETR2 and the 2^{nd}-1 functional layer HTR2.

In some embodiments, the 1^{st}-1 functional layer HTR1 (or the first hole transport layer) may include a plate-type material, and the 2^{nd}-1 functional layer HTR2 (or the second hole transport layer) may include a bulk material. In this case, at the edge of the protrusion PRT, the 1^{st}-1 functional layer HTR1 may be bent and disconnected, and the 2^{nd}-1 functional layer HTR2 may not be disconnected. Accordingly, each of the first emission structure EU1 and the intermediate layer CGL may be disconnected or discontinuous, and each of the second emission structure EU2 and the cathode electrode CE may be connected or continuous.

The occurrence of side leakage may be reduced (e.g., may be prevented) by cutting the intermediate layer CGL, and the sub-pixels may be driven normally by the connection of the cathode electrode CE.

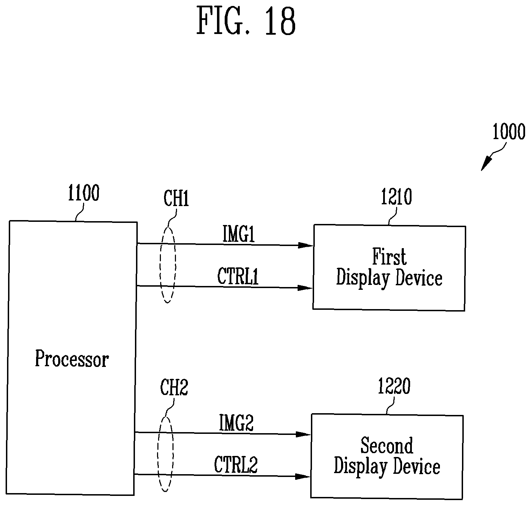

FIG. 18 is a block diagram illustrating a display system, according to some embodiments of the present disclosure.

Referring to FIG. 18, a display system 1000 may include a processor 1100 and one or more display devices 1210 and 1220.

The processor 1100 may perform various tasks and calculations. In some embodiments, the processor 1100 may include an application processor, a graphics processor, a microprocessor, a central processing unit (CPU), and/or the like. The processor 1100 may be connected to other components of the display system 1000 through a bus system and control the components of the display system 1000.

FIG. 18 illustrates that the display system 1000 includes first and second display devices 1210 and 1220. The processor 1100 may be connected to the first display device 1210 through a first channel CH1 and connected to the second display device 1220 through a second channel CH2.

The processor 1100 may transmit first image data IMG1 and first control signal CTRL1 to the first display device 1210 through the first channel CH1. The first display device 1210 may display an image based on the first image data IMG1 and the first control signal CTRL1. The first display device 1210 may be configured similarly to the display device 100 described with reference to FIG. 1. In this case, the first image data IMG1 and the first control signal CTRL1 may be provided as the input image data IMG and the control signal CTRL of FIG. 1, respectively.

The processor 1100 may transmit the second image data IMG2 and the second control signal CTRL2 to the second display device 1220 through the second channel CH2. The second display device 1220 may display an image based on the second image data IMG2 and the second control signal CTRL2. The first display device 1220 may be configured similarly to the display device 100 described with reference to FIG. 2. In this case, the second image data IMG2 and the second control signal CTRL2 may be provided as the input image data IMG and the control signal CTRL of FIG. 1, respectively.

The display system 1000 may include a computing system that provides an image display function, such as a portable computer, a mobile phone, a smart phone, a tablet personal computer, a smart watch, a watch phone, a portable multimedia player (PMP), a navigation system, or an ultra mobile personal computer (UMPC). In some embodiments, the display system 1000 may include at least one selected from a head mounted display (HMD), a virtual reality (VR) device, a mixed reality (MR) device, or an augmented reality (AR) device.

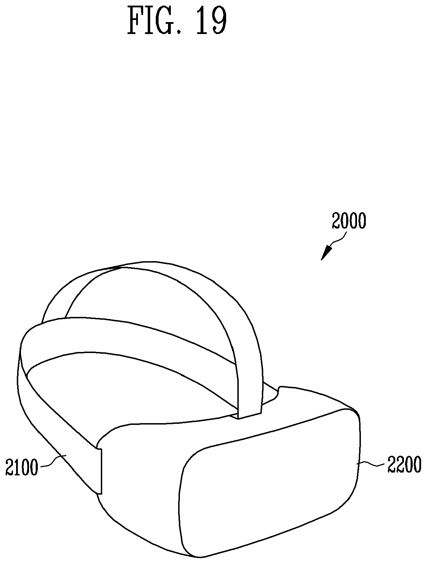

FIG. 19 is a perspective view illustrating an application example of the display system of FIG. 18.

Referring to FIG. 19, the display system 1000 of FIG. 18 may be applied to an HMD device 2000. The HMD device 2000 may be a wearable electronic device that is wearable on a user's head.

The HMD device 2000 may include a head mounted band 2100 and a display device storage case 2200. The head mounting band 2100 may be connected to the display device storage case 2200. The head mounted band 2100 may include a horizontal band and/or a vertical band for fixing the HMD device 2000 to the user's head. The horizontal band may be configured to surround the sides of the user's head, and the vertical band may be configured to surround the upper portion of the user's head. However, the present disclosure is not limited thereto. For example, the head mounted band 2100 may be implemented in the form of glasses frames, helmets, and/or the like.

The display device storage case 2200 may accommodate the first and second display devices 1210 and 1220 of FIG. 18. The display device storage case 2200 may further accommodate the processor 1100 of FIG. 18.

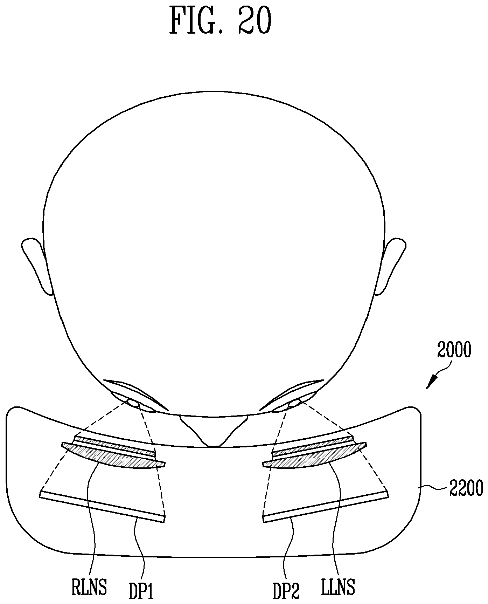

FIG. 20 is a diagram illustrating the application example of FIG. 19 worn by a user, according to some embodiments of the present disclosure.

Referring to FIG. 20, the HMD device 2000 (or the wearable electronic device) may include a display panel that emits light and a lens unit disposed on the display panel (or on the light emission path). The display panel may include a first display panel DP1 of the first display device 1210 and a second display panel DP2 of the second display device 1220. The lens unit may include one or more lenses (LLNS and RLNS).

The right eye lens RLNS may be disposed between the first display panel DP1 and the user's right eye within the display device storage case 2200. The left eye lens LLNS may be disposed between the second display panel DP2 and the user's left eye within the display device storage case 2200.

An image output from the first display panel DP1 may be displayed to the user's right eye through the right eye lens RLNS. The right eye lens RLNS may refract light from the first display panel DP1 so as to be directed toward the user's right eye. The right eye lens RLNS may perform an optical function for adjusting the viewing distance between the first display panel DP1 and the user's right eye.

An image output from the second display panel DP2 may be displayed to the user's left eye through the left eye lens LLNS. The left eye lens LLNS may refract light from the second display panel DP2 so as to be directed toward the user's left eye. The left eye lens LLNS may perform an optical function for adjusting the viewing distance between the second display panel DP2 and the user's left eye.

In some embodiments, the right eye lens RLNS and the left eye lens LLNS may each include an optical lens having a pancake-shaped cross section. In some embodiments, the right eye lens RLNS and the left eye lens LLNS may each include a multi-channel lens including sub-regions with different optical properties. In this case, each display panel may output images corresponding to the sub-regions of the multi-channel lens, and the output images may pass through the respective sub-regions and may be displayed to the user.

In a display device and a wearable electronic device according to some embodiments of the present disclosure, sub-pixels may each include a first emission structure, an intermediate layer, and a second emission structure, which are sequentially stacked between a first electrode and a second electrode. In a boundary area of the sub-pixels, the first emission structure and the intermediate layer may be disconnected, and the second emission structure and a cathode electrode may be continuous. Because the intermediate layer is disconnected in the boundary area, leakage current between the sub-pixels through the intermediate layer may be reduced, and the sub-pixels may emit light with a desired luminance.

In some embodiments, because the second emission structure and the cathode electrode are continuous in the boundary area, the sub-pixels may be driven normally.

Effects according to the some embodiments are not limited by the description presented above, and more various effects are incorporated in the present specification.

Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various aspects of example embodiments and is not to be construed as limited to the specific embodiments disclosed herein, and that various modifications to the disclosed embodiments, as well as other aspects of example embodiments, are intended to be included within the scope of the present disclosure as defined in the appended claims, and their equivalents.

## Claims

1. A display device comprising:
a base layer defining a trench; a first sub-pixel and a second sub-pixel at opposite sides of the trench, each of the first sub-pixel and the second sub-pixel comprising:
a first electrode on the base layer;
a first emission structure on the first electrode and configured to emit light, the first emission structure comprising a first hole transport layer, a first emission layer, and a first electron transport layer, a thickness of the first hole transport layer being less than a depth of the trench;
a first intermediate layer on the first emission structure;
a second emission structure on the first intermediate layer and configured to emit light, the second emission structure comprising a second hole transport layer, a second emission layer, and a second electron transport layer, a thickness of the second hole transport layer being greater than the depth of the trench; and
a second electrode on the second emission structure.

2. The display device of claim 1, wherein the trench comprises:
a first trench surrounding the first sub-pixel in a plan view; and
a second trench surrounding the second sub-pixel in a plan view, and
wherein the first trench and the second trench are spaced apart from each other.

3. The display device of claim 1 or claim 2, wherein the depth of the trench is about 2,500 Å to about 8,500 Å, a width of the trench is about 800 Å to about 1,700 Å,
wherein the thickness of the first hole transport layer is about 1,200 Å to about 1,650 Å, and
wherein the thickness of the second hole transport layer is about 3,600 Å to about 4,400 Å.

4. The display device of any one of claims 1 to 3, wherein the first hole transport layer comprises a material different from that of the second hole transport layer.

5. The display device of claim 4, wherein a glass transition temperature of the second hole transport layer is higher than a glass transition temperature of the first hole transport layer by about 10% to about 30%, optionally wherein the glass transition temperature of the second hole transport layer is higher than the glass transition temperature of the first hole transport layer by about 15°C to about 35°C.

6. The display device of any one of claims 1 to 5, wherein a thickness of the second electrode is about 100 Å to about 190 Å, optionally wherein a step of the second electrode on the trench is about 500 Å or less.

7. The display device of any one of claims 1 to 6, wherein a thickness of the first emission structure is less than the depth of the trench, and
wherein a thickness of the second emission structure is greater than the depth of the trench.

8. The display device of claim 7, wherein the thickness of the first emission structure is less than or equal to about 70% of the depth of the trench, and
wherein the thickness of the second emission structure is greater than or equal to about 160% of the depth of the trench.

9. The display device of claim 7 or claim 8, wherein the depth of the trench is about 2,500 Å to about 8,500 Å, a width of the trench is about 800 Å to about 1,700 Å,
wherein the thickness of the first emission structure is about 1,650 Å to about 2,050 Å, and
wherein the thickness of the second emission structure is about 4,500 Å to about 5,400 Å.

10. The display device of any one of claims 1 to 9, wherein the first emission structure and the first intermediate layer of the first sub-pixel are spaced apart from the first emission structure and the first intermediate layer of the second sub-pixel at the trench, and
wherein at least a portion of the second emission structure of the first sub-pixel and at least a portion of the second emission structure of the second sub-pixel are connected on the trench, optionally wherein the first sub-pixel and the second sub-pixel each comprise:
a third emission structure located between the first electrode and the first emission structure and configured to emit light; and
a second intermediate layer located between the third emission structure and the first emission structure,
the third emission structure and the second intermediate layer of the first sub-pixel being spaced apart from the third emission structure and the second intermediate layer of the second sub-pixel at the trench.

11. The display device of any one of claims 1 to 10, wherein:
(i) the first emission structure is configured to emit light of a first color, and
the second emission structure is configured to emit light of a second color different from the first color; or
(ii) the first emission structure and the second emission structure are configured to emit light of a same color.

12. A display device comprising:
a first electrode on a base layer;
a first emission structure on the first electrode and configured to emit light, the first emission structure comprising a first hole transport layer, a first emission layer, and a first electron transport layer;
an intermediate layer on the first emission structure;
a second emission structure on the intermediate layer and configured to emit light, the second emission structure comprises a second hole transport layer, a second emission layer, and a second electron transport layer, a glass transition temperature of the second hole transport layer being higher than a glass transition temperature of the first hole transport layer by about 10% to about 30%; and
a second electrode on the second emission structure.

13. The display device of claim 12, wherein a glass transition temperature of the second hole transport layer is higher than a glass transition temperature of the first hole transport layer by about 15 °C to about 35 °C.

14. A wearable electronic device comprising:
a display panel configured to emit light; and
at least one lens on the display panel, the display panel comprising:
a base layer defining a trench; and
a first sub-pixel and a second sub-pixel at opposite sides of the trench, each of the first sub-pixel and the second sub-pixel comprising:
a first electrode on the base layer;
a first emission structure on the first electrode and configured to emit light, the first emission structure comprising a first hole transport layer, a first emission layer, and a first electron transport layer, a thickness of the first hole transport layer being less than a depth of the trench;
an intermediate layer on the first emission structure;
a second emission structure on the intermediate layer and configured to emit light, the second emission structure comprising a second hole transport layer, a second emission layer, and a second electron transport layer, a thickness of the second hole transport layer being greater than the depth of the trench; and
a second electrode on the second emission structure.

15. The wearable electronic device of claim 14, wherein:
(i) a glass transition temperature of the second hole transport layer is higher than a glass transition temperature of the first hole transport layer by about 10% to about 30%; and/or
(ii) a glass transition temperature of the second hole transport layer is higher than a glass transition temperature of the first hole transport layer by about 15 °C to about 35 °C.
